# EUROPEAN PATENT APPLICATION

(11) **EP 4 693 402 A1**
(43) Date of publication of application: **11.02.2026**
(21) Application number: 24778979.5
(22) Date of filing: 27.02.2024
(51) Int. Cl.: H01L 25/07, H01L 25/18, H01L 23/473, H02M 7/48

(54) **POWER MODULE**

(30) Priority: 31.03.2023 JP 2023058351
(71) Applicant: Tohoku University, Aoba-ku Sendai-shi Miyagi 980-8577 (JP)
(72) Inventor: SUZUKI, Keita, Sendai-shi, Miyagi 980-8577 (JP); TAKAHASHI, Yoshikazu, Sendai-shi, Miyagi 980-8577 (JP); ENDOH, Tetsuo, Sendai-shi, Miyagi 980-8577 (JP)
(74) Representative: Hasegawa, Kan
(86) International application number: PCT/JP2024/007166
(87) International publication number: WO 2024/202838

(57) **Abstract**

A smaller power module is provided. A power module 1 includes: a first substrate 10 configured to include at least one pair of conductive parts 11 not connected to each other, one or more power semiconductor chips 12 connected to any of the conductive parts 11, and the cooler 13 provided on a side where the conductive parts 11 are not provided, the cooler 13 being for cooling the power semiconductor chip 12; a second substrate 20 similarly configured to the first substrate 10; a first flow path forming part 30 provided on a surface of the first substrate 10 where the cooler 13 is provided, the first flow path forming part 30 forming a first flow path 51 together with the first substrate 10; a second flow path forming part 40 provided on a surface of the second substrate 20 where the cooler 23 is provided, the second flow path forming part 40 forming a second flow path 52 together with the second substrate 20, a surface of the first substrate 10 where the pair of conductive parts 11 are provided is opposed to and spaced apart from a surface of the second substrate 20 where the pair of conductive parts 21 are provided.

## Description

### TECHNICAL FIELD

The present invention relates to a power module used in a power conversion device that converts between AC and DC.

### BACKGROUND ART

In electric and hybrid vehicles, an inverter including an upper arm and a lower arm is used to convert DC to AC between a battery and a motor that acts as a load. A power conversion device with an inverter has a power semiconductor chip for the upper arm and a power semiconductor chip for the lower arm, which are arranged near a capacitor provided for smoothing (Patent Literature 1).

### CITATION LIST

### PATENT LITERATURE

Patent Literature 1: Japanese Unexamined Patent Application Publication No. 2012-84708

### SUMMARY OF INVENTION

### TECHNICAL PROBLEM

As described above, a power conversion device with an inverter has a power semiconductor chip for the upper arm and a power semiconductor chip for the lower arm, which are arranged in a plane near the smoothing capacitor, which provides a larger footprint.

In view thereof, one of the purposes of the present invention is to provide a smaller power module. Others purposes will be described in the description of embodiments

### SOLUTION TO PROBLEM

A power module according to the present invention includes:
a first substrate configured to include at least one pair of conductive parts not connected to each other, one or more power semiconductor chips connected to any of the conductive parts, and a cooler provided on a side where no conductive parts are provided, the cooler being for cooling the power semiconductor chip;
a second substrate configured to include at least one pair of conductive parts not connected to each other, one or more power semiconductor chips connected to any of the conductive parts, and a cooler provided on a side where no conductive parts are provided, the cooler being for cooling the power semiconductor chip;
a first flow path forming part provided on a side of the first substrate where the cooler is provided, the first flow path forming part forming a first flow path for flowing a refrigerant to the cooler in the first substrate together with the first substrate together; and
a second flow path forming part provided on a side of the second substrate where the cooler is provided, the second flow path forming part forming a second flow path for flowing a refrigerant to the cooler in the second substrate together with the second substrate, wherein
a surface of the side of the first substrate where the pair of conductive parts are provided is opposed to and spaced apart from a surface of the side of the second substrate where the pair of conductive parts are provided.

### EFFECTS OF INVENTION

According to the present invention, a first substrate and a second substrate are spaced apart, with the surfaces where pairs of conductive parts are provided facing each other, a first flow path forming part is provided on the side of the first substrate where the pair of conductive parts are not provided and a cooler is provided, the first flow path forming part forming a first flow path together with the first substrate, and a second flow path forming part is provided on the side of the second substrate where the pair of conductive parts are not provided and a cooler is provided, the second flow path forming part forming a second flow path together with the second substrate, thus the first substrate and the second substrate are arranged so that they are at least overlapping when viewed in the thickness direction. This provides power semiconductor chips arranged three-dimensionally, providing a smaller power module.

### BRIEF DESCRIPTION OF DRAWINGS

FIG. 1 is a cross-sectional view along line II-II schematically illustrating a power module according to the present invention.
FIG. 2 is a cross-sectional view along line I-I schematically illustrating a power module according to the present invention.
FIG. 3 is a cross-sectional view along line IV-IV schematically illustrating a power module according to the present invention.
FIG. 4 is a cross-sectional view along line III-III schematically illustrating a power module according to the present invention.
FIG. 5 shows a cross-sectional view along line V-V schematically illustrating a power module according to the present invention.
FIG. 6 is a cross-sectional view along line IV-IV schematically illustrating a power module according to the present invention.
FIG. 7 a is a cross-sectional view schematically illustrating a power module according to the present invention.
FIG. 8 is a diagram showing a pair of conductive parts included in a first substrate and a pair of conductive parts included in a second substrate as shown in FIGs. 1 to 7.
FIG. 9 is a circuit diagram including a power module according to the present invention.
FIG. 10 is a perspective view from above of a power module according to an embodiment of the present invention.
FIG. 11 is a perspective view from below of a power module according to an embodiment of the present invention.
FIG. 12 is a perspective view of components of a power module according to an embodiment of the present invention.
FIG. 13 is a diagram showing a pair of conductive parts and a plate portion of a cooler on a first substrate in a power module according to an embodiment of the present invention.
FIG. 14 is a diagram showing a pair of conductive parts and a plate portion of a cooler on a second substrate in a power module according to an embodiment of the present invention.
FIG. 15 is a view showing a cross-sectional view along plane XV-XV in FIG. 10.
FIG. 16 is a view showing a partially enlarged view of the cross-section shown in FIG. 15.
FIG. 17A is a cross-sectional view along line XVII-XVII in FIG. 15.
FIG. 17B is the cross-sectional view in FIG. 17A with power module component including the second substrate removed from a second flow path forming part.
FIG. 18 is a partially enlarged view of the cross-section shown in FIG. 17A.
FIG. 19 is a block diagram of a power conversion device including a power module according to an embodiment of the present invention.
FIG. 20A is an image of a prototype power module as viewed from diagonally above.
FIG. 20B is a diagram showing the main outline of FIG. 20A.
FIG. 21A is an image of the power module component removed from the second flow path forming part of the prototype power module, as viewed from diagonally above.
FIG. 21B is a diagram showing the main outline of FIG. 21A.
FIG. 22A is an image of the power module component removed from the second flow path forming part of the prototype power module, as viewed with the second substrate of the power module component facing up.
FIG. 22B is a diagram showing the main outline of FIG. 22A.
FIG. 23A is an image of the second flow path forming part of the prototype power module.
FIG. 23B is a diagram showing the main outline of FIG. 23A.
FIG. 24A is a diagram showing the results of simulating heat distribution in a power module included in a three-phase inverter.
FIG. 24B is a diagram showing the simulation results in FIG. 24A along with the outlines of a first conductive part, a second conductive part, and a power semiconductor chip.

### DESCRIPTION OF EMBODIMENTS

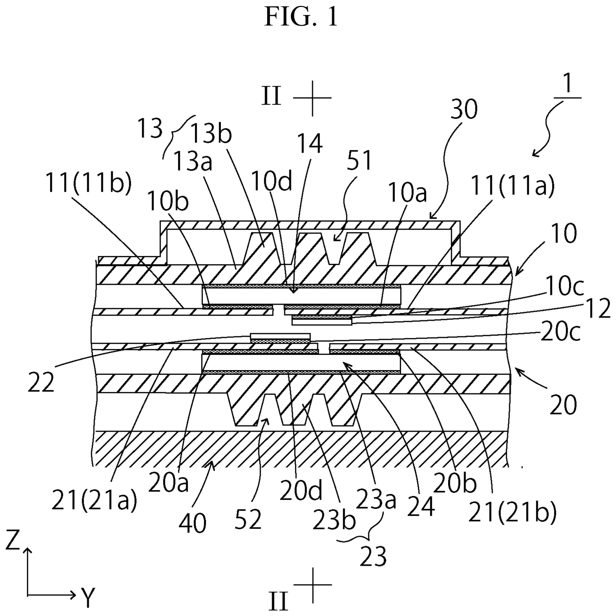

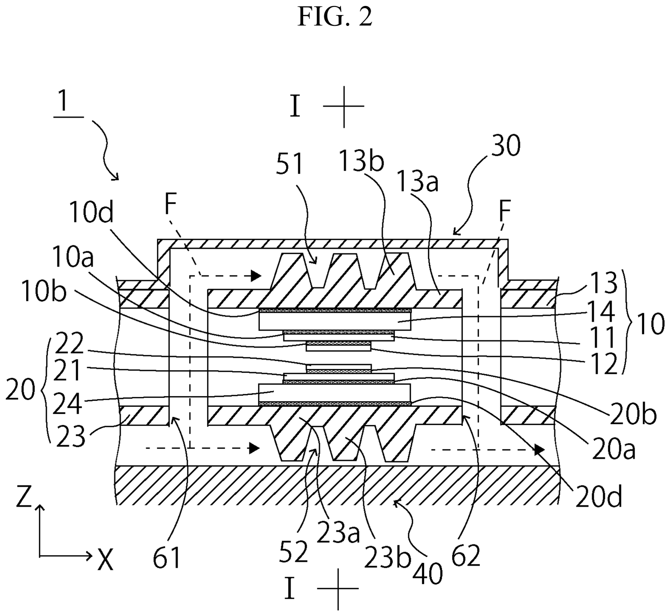

With reference to the drawings, the basic concept of the present invention will be described. FIG. 1 is a cross-sectional view along line II-II schematically illustrating a power module according to the present invention. FIG. 2 is a cross-sectional view along line I-I schematically illustrating a power module according to the present invention. A power module 1 according to the present invention is housed in a not-shown case, connected to a capacitor inside the case, and connected between a battery provided either inside or outside the case and a load such as a motor.

The power module 1 includes a first substrate 10, a second substrate 20, a first flow path forming part 30, and a second flow path forming part 40. The first substrate 10 is opposed to and spaced apart in the thickness direction from the second substrate 20.

The first substrate 10 is configured by including at least one pair of conductive parts 11 not connected to each other, one or more power semiconductor chips 12 connected to any of the conductive parts 11, and a cooler 13 provided on the side (surface) where the conductive parts 11 are not provided, the cooler 13 is for cooling the power semiconductor chips 12. In the example shown, a first conductive part 11a pairs with a second conductive part 11b, one power semiconductor chip 12 is installed on the first conductive part 11a, and the first conductive part 11a is connected to the power semiconductor chip 12. In so doing, the power semiconductor chip 12 is connected to the first conductive part 11a via a bonding layer 10c, including a metal layer (alloy layer) such as solder, or a nano-silver bonding layer. The second conductive part 11b is provided on the same side (same surface) as the first conductive part 11a. The cooler 13 is provided on the opposite surface where the first conductive part 11a and the second conductive part 11b are not provided. Here, the first conductive part 11a is not electrically connected to the second conductive part 11b.

The second substrate 20 is configured by including at least one pair of conductive parts 21 not connected to each other, one or more power semiconductor chips 22 connected to any of the conductive parts 21, and a cooler 23 provided on the side (surface) where the conductive parts 21 are not provided, the cooler 23 is for cooling the power semiconductor chips 22. In the example shown, a first conductive part 21a pairs with a second conductive part 21b, one power semiconductor chip 22 is installed on the first conductive part 21a, and the first conductive part 21a is connected to the power semiconductor chip 22. In so doing, the power semiconductor chip 22 is connected to the first conductive part 21a via a bonding layer 20c, including a metal layer (alloy layer) such as solder, or a nano-silver bonding layer. The second conductive part 21b is provided on the same side (same surface) as first conductive part 21a. The cooler 23 is provided on the opposite surface where the first conductive part 21a and the second conductive part 21b are not provided. Here, the first conductive part 21a is not electrically connected to the second conductive part 21b.

The surface where the first conductive part 11a and the second conductive part 11b are provided in the first substrate 10 is opposed to and spaced apart in the thickness direction from the surface where the first conductive part 21a and the second conductive part 21b are provided in the second substrate 20. The power semiconductor chip 22 in the second substrate 20 may at least partially overlap the power semiconductor chip 12 in the first substrate 10 in the thickness direction.

The first flow path forming part 30 is provided on the side where the cooler 13 of the first substrate 10 is provided and forms the flow path 51 for flowing refrigerant to the cooler 13 of the first substrate 10 together with the first substrate 10.

The second flow path forming part 40 is provided on the side where the cooler 23 of the second substrate 20 is provided and forms the flow path 52 for flowing refrigerant to the cooler 23 of the second substrate 20 together with the second substrate 20.

According to a power module 1 of the present invention, first, the second substrate 20 is opposed to and spaced apart in the thickness direction from the first substrate 10, second, the first flow path forming part 30 is provided on the first substrate 10 on the opposite side to the second substrate 20, the first flow path forming part 30 forms the first flow path 51 for flowing refrigerant to the first cooler 13 together with the first substrate 10, and third, the second flow path forming part 40 is provided on the second substrate 20 on the opposite side to the first substrate 10, the second flow path forming part 40 forms the second flow path 52 for flowing refrigerant to the second cooler 23 together with the second substrate 20. Thus, the first substrate 10 and the second substrate 20 are arranged so that they at least overlap when viewed in the thickness direction. This allows the power semiconductor chips 12 and 22 to be arranged three-dimensionally, enabling the power module 1 to be small-sized and, consequently, the power conversion device to be also small-sized.

That is, in the power module 1 according to the present invention, the first substrate 10 and the second substrate 20 have a two-layer or two-story structure, and the first flow path and the second flow path are formed in parallel. This eliminates the conventional need to increase a single substrate in planar size and allows smaller planar dimensions of the power module 1, thus decreasing the size of the power conversion device itself configured to house power module 1 within a case.

In the power module 1 according to the present invention, as shown in FIG. 2, a flow path is provided between the first substrate 10 and the second substrate 20 that connects the first flow path 51 and the second flow path 52 in the thickness direction (Z-axis direction), but a flow path is not provided in parallel to the first flow path 51 and the second flow path 52. This may provide a smaller distance between the first substrate 10 and the second substrate 20, and reduce the increase in thickness due to the two-layer structure or two-story structure by the first substrate 10 and the second substrate 20.

Next, a description will be given of an embodiment selectively applicable to the power module 1 according to the present invention. As shown in FIG. 2, the power module 1 includes a branch section 61. The branch section 61 connects the first flow path 51 formed by the first flow path forming part 30 and the first substrate 10 to the second flow path 52 formed by the second flow path forming part 40 and the second substrate 20. The branch section 61 is provided upstream of the power semiconductor chip 12 in the first substrate 10 and the power semiconductor chip 22 in the second substrate 20.

The second flow path 52 is provided in parallel with the first flow path 51, and the flow of refrigerant in the second flow path 52 is along the flow of refrigerant in the first flow path 51. Thus, the flow paths F of refrigerant are in parallel between the first flow path and the second flow path. This makes the cooling by the refrigerant flowing through the first flow path 51 similar to the cooling by the refrigerant flowing through the second flow path 52. This may reduce temperature variations during operation between the power semiconductor chip 12 in the first substrate 10 and the power semiconductor chip 22 in the second substrate 20.

As a further selectively applicable embodiment, as shown in FIG. 2, the power module 1 includes a confluence section 62. The confluence section 62 connects the first flow path 51 formed by the first flow path forming part 30 and the first substrate 10 to the second flow path 52 formed by the second flow path forming part 40 and the second substrate 20. The confluence section 62 is provided downstream of the power semiconductor chip 12 in the first substrate 10 and the power semiconductor chip 22 in the second substrate 20.

As shown in FIG. 2, the branch section 61 and the confluence section 62 may be provided to pass through the first substrate 10 and the second substrate 20 (a plate portion 13a and a plate portion 23a) in the thickness direction (Z-axis direction). A line extends from the inlet of the second flow path 52 in one direction opposite to the flow of refrigerant and is connected to the inlet port (not shown) of refrigerant, and extends from the outlet of the second flow path 52 along the flow of refrigerant and is connected to the outlet port (not shown) of refrigerant. The refrigerant flows as shown by flow F in the order of the inlet port, the branch section 61, the confluence section 62, and the outlet port. The second flow path forming part 40 is a part of the case of the power conversion device or a member installed in the case. The power module 1 may be assembled or arranged by placing the power module component including the first substrate 10, the second substrate 20, and the first flow path forming part 30 on the second flow path forming part 40, which is the part of the case or the member.

That is, the power module component includes: the first substrate 10 configured by including at least one pair of conductive parts 11 (11a, 11b) not connected to each other, one or more power semiconductor chips 12 connected to any of the conductive parts 11 (11a, 11b), and the cooler 13 provided on the side (surface) where the conductive parts 11 (11a, 11b) are not provided, the cooler 13 being for cooling the power semiconductor chips 12; the second substrate 20 configured by including at least one pair of conductive parts 21 (21a, 21b) not connected to each other, one or more power semiconductor chips 22 connected to any of the conductive parts 21 (21a, 21b), and the cooler 23 provided on the side (surface) where the conductive parts 21 (21a, 21b) are not provided, the cooler 23 being for cooling the power semiconductor chips 22; and the first flow path forming part 30 provided on the side (surface) where the cooler 23 of the first substrate 10 is provided, the first flow path forming part 30 forming the first flow path 51 for flowing refrigerant to the cooler 23 in the first substrate 10 together with the first substrate 10. The surface of the side of the first substrate 10 where the pair of conductive parts 11 are provided is opposed to and spaced apart from the surface of the side of the second substrate 20 where the pair of conductive parts 21 are provided. The cooler 23 in the second substrate 20 is attached to a part of the second flow path forming part 40 or the second flow path forming part 40 formed in a portion of the case, so that the second flow path forming part 40 forms the second flow path 52 for flowing refrigerant to the cooler 23 in the second substrate 20 together with the second substrate 20.

In the power module 1, the inlet port of refrigerant may be connected to the extension of the second flow path 52 in the opposite direction to the flow of refrigerant so that the refrigerant flows to the branch section 61, and the outlet port of refrigerant may be connected by being extended from the first flow path 51 along the flow of refrigerant, without being extended from the confluence section 62 of the second flow path 52.

In either embodiment, the branch section 61 and the confluence section 62 that connect the first flow path 51 and the second flow path 52 may be provided inside the power module 1, facilitating installation of the power module 1 or the power module component, and assembly of the power conversion device.

Next, a description will be given of another embodiment selectively applicable to the power module 1 according to the present invention. Regardless of whether the branch section 61 and the confluence section 62 are provided, the cooler 13 in the first substrate 10 includes a plate portion 13a and a plurality of protrusions 13b extending from the plate portion 13a toward the corresponding flow path (first flow path 51). The cooler 23 in the second substrate 20 includes a plate portion 23a and a plurality of protrusions 23b extending from the plate portion 23a toward the corresponding flow path (second flow path). It is preferable that either or both of the protrusions 13b and protrusions 23b have a shape such as a pin or fin. The dimensions shown in FIGs. 1 and 2 are not correct. The protrusions 13b increase the contact area with the refrigerant flowing through the first flow path 51, allowing heat generated in the power semiconductor chip 12 to be transferred to the pins or fins. Likewise, the protrusions 23b increase the contact area with the refrigerant flowing through the second flow path 52, allowing heat generated in the power semiconductor chip 22 to be transferred to the pins or fins. This may provide efficient cooling.

The protrusions 13b and protrusions 23b may be selected from any of the following shapes: a generally cylindrical shape including a cylindrical shape; a triangular prism, a quadrangular prism, or other polygonal prism; a generally conical shape whose cross sectional area decreases toward the tip; a triangular pyramid shape, a square pyramid shape, or other polygonal pyramid shape. The protrusions 13b and the protrusions 23b may have the same or different shapes. The protrusions 13b and protrusions 23b may have different dimensions at the locations where they protrude in their respective flow paths.

The protrusions 13b are provided for heat dissipation from the power semiconductor chip 12. The protrusions 23b are provided for heat dissipation from the power semiconductor chip 22. Therefore, it is unnecessary to provide the protrusions in portions of the plate portion 13a that do not contribute to heat dissipation from the power semiconductor chip 12, and in portions of the plate portion 13a that do not contribute to heat dissipation from the power semiconductor chip 22. This reduces the fluid resistance of the refrigerant in each of the first flow path 51 and the second flow path 52, contributing to reduce the size and power consumption of a pump provided either inside or outside the case of the power conversion device for delivering refrigerant to the power module 1.

The protrusions 13b of the cooler 13 in the first substrate 10 may be the same as or comparable to the protrusions 23b of the cooler 23 in the second substrate 20 in at least one of the dimensions of the protrusions themselves, the distance between the protrusions, and the distance between the tips of the protrusions and the corresponding flow path forming part.

The protrusions 13b of the cooler 13 in the first substrate 10 may differ from the protrusions 23b of the cooler 23 in the second substrate 20 in at least one of the dimensions of the protrusions themselves, the distance between the protrusions, and the distance between the tips of the protrusions and the corresponding flow path forming part. This may reduce variations in the flow rate of the refrigerant to each of the cooler 13 in the first flow path and the cooler 23 in the second flow path.

To achieve this, as a first method, the dimensions of the pins or fins are set different for protrusions 23b and the protrusions 13b. The cross-section dimensions of the protrusions 13b alone, perpendicular to the direction of projection into the first flow path 51, are set smaller than those of the protrusions 23b. Thus, the fluid resistance caused by the protrusions 13b is smaller than the fluid resistance caused by the protrusions 23b. Therefore, the flow rate of the refrigerant flowing through the first flow path 51 at the locations where the protrusions 13b are provided may be comparable to the flow rate of the refrigerant flowing through the second flow path 52 at the locations where the protrusions 23b are provided.

As a second method, the distance between the protrusions is set different for the protrusions 13b and the protrusions 23b. The distance between the protrusions 13b is set greater than that between the protrusions 23b. Thus, the fluid resistance caused by the protrusions 13b is smaller than the fluid resistance caused by the protrusions 23b. Therefore, the flow rate of the refrigerant flowing through the first flow path 51 at the locations where the protrusions 13b are provided may be comparable to the flow rate of the refrigerant flowing through the second flow path 52 at the locations where the protrusions 23b are provided.

As a third method, the area where the protrusions are provided is set different for the protrusions 13b and the protrusions 23b. The area where the protrusions 13b are provided is set smaller than that for the protrusions 23b. Thus, the fluid resistance caused by the protrusions 13b is smaller than the fluid resistance caused by the protrusions 23b. Therefore, the flow rate of the refrigerant flowing through the first flow path 51 at the locations where the protrusions 13b are provided may be comparable to the flow rate of the refrigerant flowing through the second flow path 52 at the locations where the protrusions 23b are provided.

This is effective when each substrate has a plurality of pairs of conductive parts 11, 21, rather than when each of the first substrate 10 and the second substrate 20 has one pair of conductive parts 11, 21, as shown in FIGs. 1 and 2. Each of the first substrate 10 and the second substrate 20 has portions where none of the conductive part 11 and conductive part 21 are present when viewed in the thickness direction. Therefore, the protrusions 23b may be provided in those portions of the second substrate 20, and no protrusions 13b may be provided in those portions of the first substrate 10.

As a fourth method, the gap between the tips of the protrusions 13b and the first flow path forming part 30 is set different from the gap between the tips of the protrusions 23b and the second flow path forming part 40. The gap between the tips of the protrusions 13b and the first flow path forming part 30 is set larger than the gap between the tips of the protrusions 23b and the second flow path forming part 40. Thus, the fluid resistance caused by the protrusions 13b is smaller than the fluid resistance caused by the protrusions 23b. Therefore, the flow rate of the refrigerant flowing through the first flow path 51 at the locations where the protrusions 13b are provided may be comparable to the flow rate of the refrigerant flowing through the second flow path 52 at the locations where the protrusions 23b are provided.

In the above description, the fluid resistance caused by the protrusions 13b is set smaller than the fluid resistance caused by the protrusions 23b. Conversely, if the fluid resistance caused by the protrusions 13b is set greater than the fluid resistance caused by the protrusions 23b, the following is achieved.

As a first method, the cross-section dimensions of the protrusions 13b alone, perpendicular to the direction of projection into the first flow path 51, are set greater than those of the protrusions 23b.

As a second method, the distance between the protrusions 13b is set smaller than that between the protrusions 23b.

As a third method, the area where the protrusions 13b are provided is set greater than that for the protrusions 23b. If each of the first substrate 10 and the second substrate 20 has a plurality of pairs of conductive parts 11, 21, each of the first substrate 10 and the second substrate 20 has portions where none of the conductive part 11 and conductive part 21 are present when viewed in the thickness direction. Therefore, no protrusions 23b are provided in those portions of the second substrate 20, and the protrusions 13b are provided in those portions of the first substrate 10.

As a fourth method, the gap between the tips of the protrusions 13b and the first flow path forming part 30 is set smaller than the gap between the tips of the protrusions 23b and the second flow path forming part 40.

Any one of the first to fourth methods may be selected, or any multiple methods of the first to fourth methods may be selected.

As shown in FIGs. 1 and 2, the first substrate 10 includes a circuit board 14. The first conductive part 11a is provided on the circuit board 14 via a bonding layer 10a, including a metal layer (alloy layer) such as solder, or a nano-silver bonding layer. The second conductive part 11b is provided on the circuit board 14 via a bonding layer 10b, including a metal layer (alloy layer) such as solder, or a nano-silver bonding layer. The cooler 13 is provided on the circuit board 14 via a bonding layer 10d, including a metal layer (alloy layer) such as solder, or a nano-silver bonding layer. The inclusion of the bonding layer 10a, the bonding layer 10b may provide good thermal conductivity. The inclusion of the bonding layer 10d may provide good thermal conductivity. The bonding layer 10a is not electrically connected to the bonding layer 10b.

As shown in FIGs. 1 and 2, the second substrate 20 includes a circuit board 24. The first conductive part 21a is provided on the circuit board 24 via a bonding layer 20a, including a metal layer (alloy layer) such as solder, or a nano-silver bonding layer. The second conductive part 21b is provided on the circuit board 24, via a bonding layer 20b, including a metal layer (alloy layer) such as solder, or a nano-silver bonding layer. The cooler 23 is provided on the circuit board 24, via a bonding layer 20d, including a metal layer (alloy layer) such as solder, or a nano-silver bonding layer. The inclusion of the bonding layer 20a, the bonding layer 20b may provide good thermal conductivity. The inclusion of the bonding layer 20d may provide good thermal conductivity. The bonding layer 20a is not electrically connected to the bonding layer 20b.

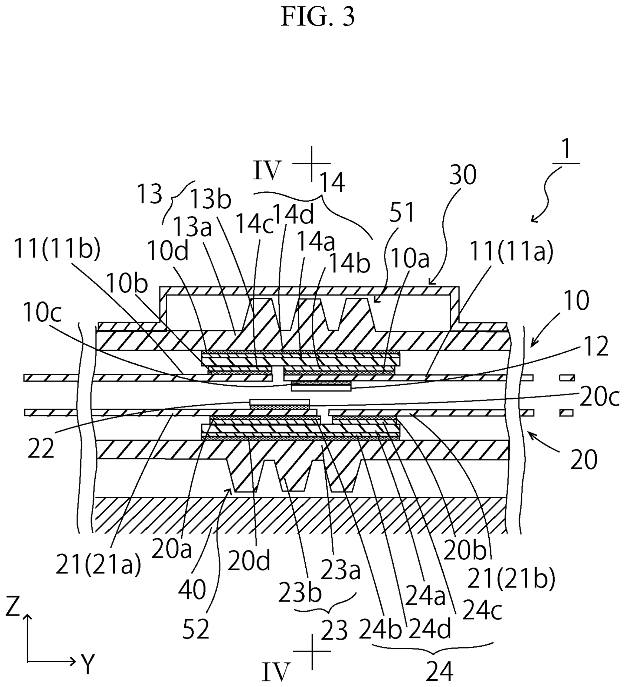

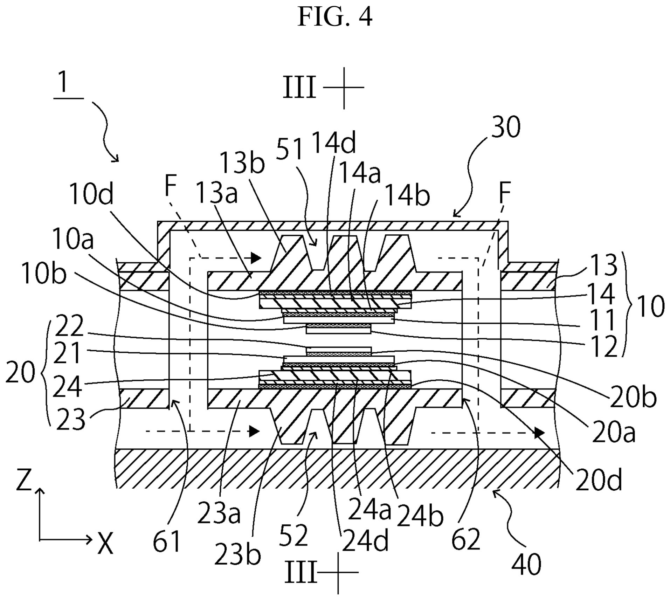

Next, a description will be given of another embodiment selectively applicable to the power module 1 according to the present invention. FIG. 3 is a cross-sectional view along line IV-IV schematically illustrating a power module according to the present invention. FIG. 4 is a cross-sectional view along line III-III schematically illustrating a power module according to the present invention.

As shown in FIGs. 3 and 4, the circuit board 14 is configured to include an insulating substrate 14a, a metal layer 14b and a metal layer 14c having interconnection patterns on the insulating substrate 14a, and a metal layer 14d for attaching the cooler 13 to the surface where none of the metal layer 14b and metal layer 14c are formed. As described above, the circuit board 14 has a first surface and a second surface, the first surface has the metal layer 14b and the metal layer 14c provided thereon, and the second surface has the metal layer 14d provided thereon. The bonding layer 10a bonds the metal layer 14b and the first conductive part 11a. The bonding layer 10b bonds the metal layer 14c and the second conductive part 11b. The bonding layer 10d bonds the metal layer 14d and the cooler 13. The metal layer 14b is not electrically connected to the metal layer 14c.

The circuit board 24 is configured to include an insulating substrate 24a, a metal layer 24b and a metal layer 24c having interconnection patterns on the insulating substrate 24a, and a metal layer 24d for attaching the cooler 23 to the surface where none of the metal layer 24b and metal layer 24c are formed. As described above, the circuit board 24 has a first surface and a second surface, the first surface has the metal layer 24b and the metal layer 24c provided thereon, and the second surface has the metal layer 24d provided thereon. The bonding layer 20a bonds the metal layer 24b and the first conductive part 21a. The bonding layer 20b bonds the metal layer 24c and the second conductive part 21b. The bonding layer 20d bonds the metal layer 24d and the cooler 23. The metal layer 24b is not electrically connected to the metal layer 24c.

The first surface of the circuit board 24 is opposed to the first surface of the circuit board 14 in the first substrate 10. In other words, the first surface is an opposing surface, and the second surface is a no-opposing surface. When the cooler 13 is configured by including the plate portion 13a and the protrusions 13b, and the cooler 23 is configured by including the plate portion 23a and protrusions 23b, the plate portion 13a is provided on the second surface of the circuit board 14, and the plate portion 23a is provided on the second surface of the circuit board 24. The insulating substrate 14a and the insulating substrate 24a are made of insulating materials such as silicon nitride and aluminum nitride.

The circuit board 14 includes a substrate, such as a Direct Copper Bonding (DCB) substrate, in which the metal layer 14b and the metal layer 14c including copper, aluminum, or the like are bonded to the first surface of the insulating substrate 14a, and the metal layer 24d including copper, aluminum, or the like is bonded to the second surface of the insulating substrate 14a. The circuit board 24 includes a substrate, such as a DCB substrate, in which the metal layer 24b and the metal layer 24c including copper, aluminum, or the like are bonded to the first surface of the insulating substrate 24a, and the metal layer 24d including copper, aluminum, or the like is bonded to the second surface of the insulating substrate 14a.

The first conductive part 11a and the second conductive part 11b are provided on the circuit board 14 via the bonding layer 10a and the bonding layer 10b, respectively. The cooler 13 is provided on the circuit board 14 via the bonding layer 10d. The first conductive part 21a and the second conductive part 21b are provided on the circuit board 24 via the bonding layer 20a and the bonding layer 20b, respectively. The cooler 23 is provided on the circuit board 24 via the bonding layer 20d. This is to reduce the contact thermal resistance between the circuit board 14 and the cooler 13, and the thermal resistance between the circuit board 24 and the cooler 23, as much as possible. In other words, no heat-resistant material such as grease is interposed between the circuit board 14 and the cooler 13, or between the circuit board 24 and the cooler 23. In this way, by using direct cooling rather than indirect cooling, the heat generated in the power semiconductor chip 12 is efficiently transferred to the cooler 13, and the heat generated in the power semiconductor chip 22 is efficiently transferred to the cooler 23, thereby improving the cooling efficiency.

It is possible not to provide the metal layer 14d on the circuit board 14 and not to provide the metal layer 24d on the circuit board 24. But it is preferable to provide the metal layer 14d on the side where the metal layer 14b and the metal layer 14c are not provided, and it is preferable to provide the metal layer 24d on the side where the metal layer 24b and a the metal layer 24c are not provided, since it makes easier to mount the cooler 13 on the circuit board 14, and mount the cooler 23 on the circuit board 24. This makes it easier to transfer the heat generated in the power semiconductor chip 12 and the power semiconductor chip 22 to the cooler 13 and the cooler 23.

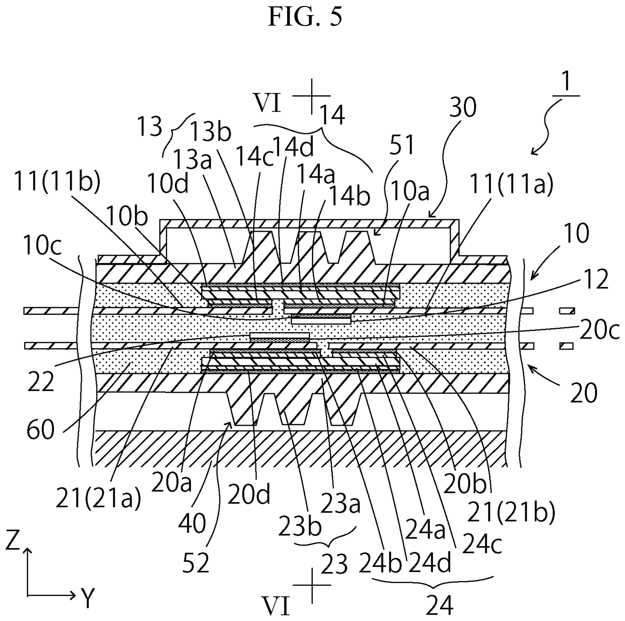

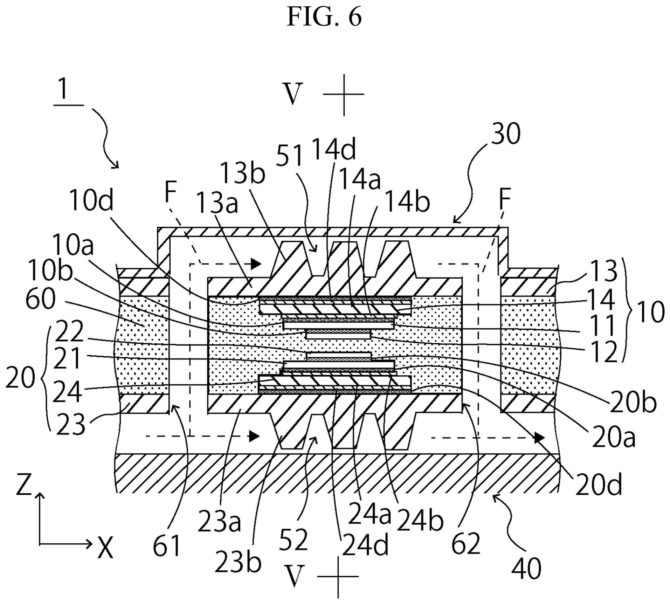

Next, a description will be given of another embodiment selectively applicable to the power module 1 according to the present invention. Between the first substrate 10 and the second substrate 20, at least around a part or the entire periphery of the outer edge between the first substrate 10 and the second substrate 20, a not-shown spacer may be provided. FIG. 5 is a cross-sectional view along line VI-VI schematically illustrating a power module according to the present invention. FIG. 6 is a cross-sectional view along line V-V schematically illustrating a power module according to the present invention. Between the opposing surfaces between the first substrate 10 and the second substrate 20, the spacer may function by a sealing part 60 made of a sealant. A part or all of the sealing part 60 may be made of an insulating material. The sealing part 60 may cover the surfaces of the pair of conductive parts 11 and the power semiconductor chip 12 in the first substrate 10, or the surfaces of the pair of conductive parts 21 and the power semiconductor chip 22 in the second substrate 20. This may electrically insulate the first substrate 10 and the second substrate 20. Note that FIGs. 1 to 6 do not show the connection between the second conductive part 11b and the power semiconductor chip 12, or the connection between the second conductive part 21b and the power semiconductor chip 22. To connect the first flow path 51 and the second flow path 52, the sealing part 60 includes one or more holes to form the branch section 61. The sealing part 60 is preferably made of a material that is less likely to have liquid leakage, such as epoxy resin.

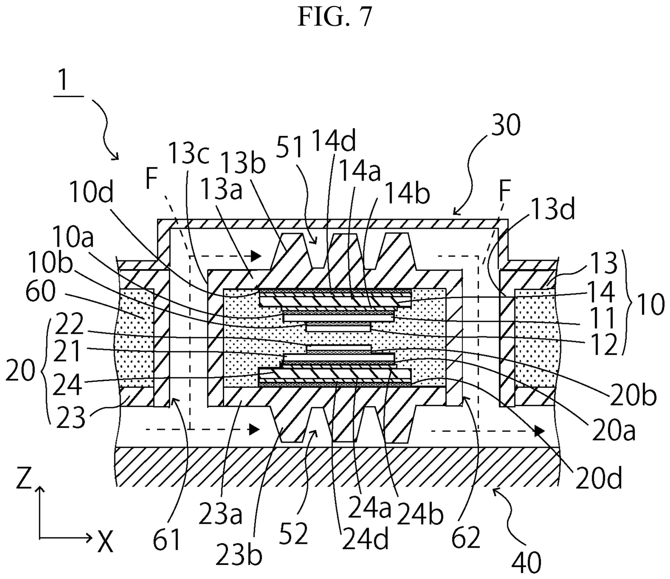

Next, a description will be given of another embodiment selectively applicable to the power module 1 according to the present invention. FIG. 7 is a cross-sectional view schematically illustrating the power module 1 according to the present invention. In the plate portion 13a of the cooler 13 in the first substrate 10, a cooling pipe 13c and a cooling pipe 13d are provided in portions that protrude on the opposite side to the protrusions 13b and do not have the protrusions 13b (specifically, the portions of the branch section 61 and the confluence section 62). Then, the first substrate 10 and the second substrate 20 are spaced apart in the thickness direction, and the tips of the cooling pipe 13c and the cooling pipe 13d are connected to the plate portion 23a of the second substrate 20 by welding or the like. This may provide high performance prevention of refrigerant leakage at the connection between the first flow path 51 and the second flow path 52 regardless of the material of the sealing part 60. The cooling pipe 13c and the cooling pipe 13d are preferably made of the same material (metal) as the plate portion 13a.

Unlike the above configuration, in the plate portion 23a of the cooler 23 in the second substrate 20, a cooling pipe 23c and a cooling pipe 23d are provided in portions that protrude on the opposite side to the protrusions 23b and do not have the protrusions 23b (specifically, the portions of the branch section 61 and the confluence section 62). Then, the first substrate 10 and the second substrate 20 may be spaced apart in the thickness direction, the tips of the cooling pipe 23c and the cooling pipe 23d may be connected to the plate portion 13a in the first substrate 10 by welding or the like. This may prevent refrigerant leakage at the connection between the first flow path 51 and the second flow path 52 regardless of the material of the sealing part 60. The cooling pipe 13c and the cooling pipe 13d are preferably made of the same material (metal) as the plate portion 13a.

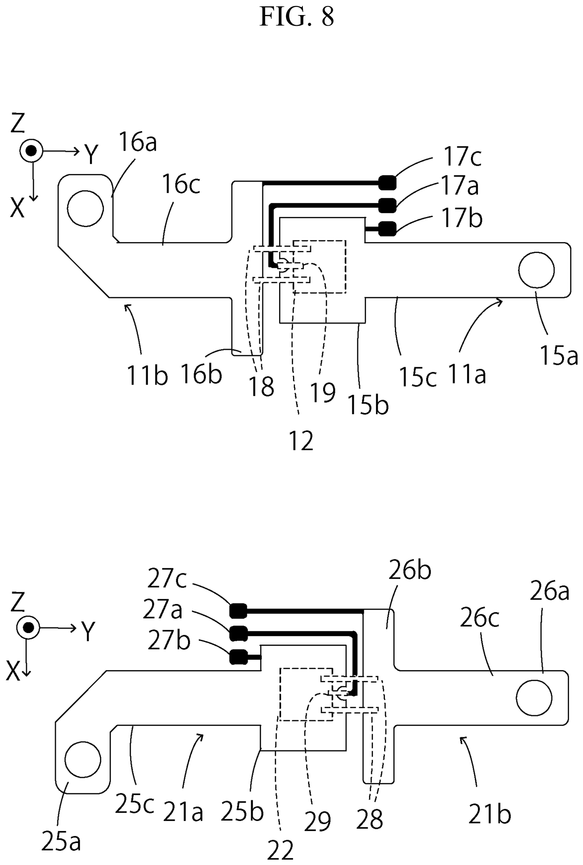

Next, a description will be given of another embodiment selectively applicable to the power module 1 according to the present invention. FIG. 8 is a diagram showing the pair of conductive parts 11 (11a, 11b) included in the first substrate 10 and the pair of conductive parts 21 (21a, 21b) included in the second substrate 20 as shown in FIGs. 1 to 6. The upper part of FIG. 8 shows the pair of conductive parts 11 (11a, 11b). The lower part of FIG. 8 shows the pair of conductive parts 21 (21a, 21b) included in the second substrate 20. FIG. 8 shows parts of metal layers in black that are connected to the pair of conductive parts 11 (11a, 11b) and the pair of conductive parts 21 (21a, 21b) in the Z-axis direction by the bonding layers 10a, 10b, 20a, 20b.

The pair of conductive parts 11 in the first substrate 10 are formed to extend oppositely to each other in directions intersecting the first flow path 51 (Y-axis direction in FIG. 8). The first conductive part 11a as one of the conductive parts includes a first AC connection terminal 15a. The second conductive part 11b as the other of the conductive parts includes a first DC connection terminal 16a. The pair of conductive parts 21 in the second substrate 20 are formed to extend oppositely to each other in directions intersecting the second flow path 52 (Y-axis direction in FIG. 8), i.e., to extend in parallel to the pair of conductive parts 21 in the first substrate 10. The first conductive part 21a as one of the conductive parts includes a second DC connection terminal 25a. The second conductive part 21b as the other of the conductive parts includes a second AC connection terminal 26a.

The current flowing through the second conductive part 11b between the first DC connection terminal 16a and the power semiconductor chip 12 in the first substrate 10 is configured to be in the opposite direction to the current flowing through the first conductive part 21a between the second DC connection terminal 25a and the power semiconductor chip 22 in the second substrate 20. The second conductive part 11b (an extension portion 16c) has generally the same shape as the first conductive part 21a (an extension portion 25c). The second conductive part 11b (an extension portion 16c) is arranged to partially overlap the first conductive part 21a (an extension portion 25c) when viewed in the thickness direction. This may reduce the inductance of the second conductive part 11b and the first conductive part 21a. The second conductive part 11b is arranged symmetrically with the first conductive part 21a with respect to the XY plane. The second conductive portion 11b is spaced apart from the first conductive portion 21a in the Z-axis direction.

Furthermore, the pair of conductive parts 11 in the first substrate 10 are configured to follow the shortest possible path from the first DC connection terminal 16a through the mounting region for the power semiconductor chip 12 to the first AC connection terminal 15a without curving or bypassing when viewed in the thickness direction. The pair of conductive parts 21 in the second substrate 20 are configured to follow the shortest possible path from the second DC connection terminal 25a through the mounting region for the power semiconductor chip 22 to the second AC connection terminal 26a without curving or bypassing when viewed in the thickness direction. This may reduce the inductance and electrical resistance, which may reduce the electric power loss as much as possible.

When the first conductive part 11a in the first substrate 10 includes the first AC connection terminal 15a, and the second conductive part 21b in the second substrate 20 includes the second AC connection terminal 26a, the first AC connection terminal 15a and the second AC connection terminal 26a are spaced apart only in the thickness direction, which may make the interconnection for connection to the load short and easily.

As shown in the upper part in FIG. 8, among the pair of conductive parts 11 provided in the first substrate 10, the first conductive part 11a includes a chip mounting portion 15b on which the power semiconductor chip 12 is mounted, and an extension portion 15c extending from the chip mounting portion 15b. The tip of the extension portion 15c forms the first AC connection terminal 15a. The second conductive part 11b includes a proximity portion 16b adjacent to the chip mounting portion 15b in a non-contact manner, and the extension portion 16c that extends from the proximity portion 16b in the opposite direction to the chip mounting portion 15b. The tip of the extension portion 16c forms the first DC connection terminal 16a. The tip of a first electrode is provided between the chip mounting portion 15b and the proximity portion 16b. The first electrode is for connecting to, for example, a gate electrode as a control electrode of the power semiconductor chip 12. A first electrode connection 17a is formed by being extracted from the tip of the first electrode. A second electrode connection 17b is provided from the chip mounting portion 15b alongside the first electrode connection 17a. The second electrode connection 17b is for connecting to, for example, a collector electrode as one of the main electrodes of the power semiconductor chip 12. A third electrode connection 17c is provided by being extracted from the proximity portion 16b along the first electrode extraction electrode. The third electrode connection 17c is for connecting to, for example, an emitter electrode as one of the main electrodes of the power semiconductor chip 12. Here, the first electrode connection 17a, the second electrode connection 17b, and the third electrode connection 17c may not be a part of the conductive parts 11. They may be provided by the metal layer 14b, the metal layer 14c, and the metal layer 14d of the circuit board 14, respectively, as shown in the figures, or may be a part of the conductive parts 11, as not shown.

The power semiconductor chip 12 includes a power semiconductor element, such as, for example, a Metal-Oxide-Semiconductor Field-Effect Transistor (MOSFET) or an Insulated Gate Bipolar Transistor (IGBT). The power semiconductor chip 12 preferably includes a vertical power semiconductor element that electrically controls the control electrode of the main electrodes on the upper and lower surfaces of the chip to turn on/pff a large current between the upper and lower main electrodes. The main electrodes on the surface of the power semiconductor chip 12 on the side of the first conductive part 11a is electrically connected to the chip mounting portion 15b via a solder or nano-silver bonding. The main electrodes on the surface of the power semiconductor chip 12 opposite to the first conductive part 11a is electrically connected to the proximity portion 16b via a connecting member 18 such as a wire or clip. The control electrode on the surface of the power semiconductor chip 12 opposite to the first conductive part 11a is electrically connected to the tip of the first electrode via a connecting member 19 such as a wire or clip. The connection between each electrode of the power semiconductor chip 12 and the first and second conductive parts 11a and 11b is not limited thereto. It is preferable to use clips rather than wires for either or both of the connecting member 18 and the connecting member 19, because this may allow the power module 1 to have a smaller dimension in the thickness direction.

As shown in the lower part of FIG. 7, among the pair of conductive parts 21 provided in the second substrate 20, the first conductive part 21a includes a chip mounting portion 25b on which the power semiconductor chip 22 is mounted, and an extension portion 25c extending from the chip mounting portion 25b. The tip of the extension portion 25c forms the second DC connection terminal 25a. The second conductive part 21b includes a proximity portion 26b adjacent to the chip mounting portion 25b in a non-contact manner, and an extension portion 26c that extends from the proximity portion 26b in the opposite direction to the chip mounting portion 25b. The tip of the extension portion 26c forms the second AC connection terminal 26a. The tip of a first electrode is provided between the chip mounting portion 25b and the proximity portion 26b. The first electrode is for connecting to, for example, a gate electrode as a control electrode of the power semiconductor chip 22. A first electrode connection 27a is formed by being extracted from the tip of the first electrode. A second electrode connection 27b is provided from the chip mounting portion 25b alongside the first electrode connection 27a. The second electrode connection 27b is for connecting to, for example, a collector electrode as one of the main electrodes of the power semiconductor chip 22. A third electrode connection 27c is provided by being extracted from the proximity portion 26b along the first electrode extraction electrode. The third electrode connection 27c is for connecting to, for example, an emitter electrode as one of the main electrodes of the power semiconductor chip 22. Here, the first electrode connection 27a, the second electrode connection 27b, and the third electrode connection 27c may not be a part of the conductive parts 21. They may be provided by the metal layer 24b, the metal layer 24c, and the metal layer 24d of the circuit board 24, respectively, as shown in the figures, or may be a part of the conductive parts 11, as not shown.

Like the power semiconductor chip 12, the power semiconductor chip 22 includes a power semiconductor element, such as, for example, a MOSFET or an IGBT. The power semiconductor chip 22 preferably includes a vertical power semiconductor element that electrically controls the control electrode of the main electrodes on the upper and lower surfaces of the chip to turn on/pff a large current between the upper and lower main electrodes. The main electrodes on the lower surface of the power semiconductor chip 22 is electrically connected to the chip mounting portion 25b via a solder or nano-silver bonding. The main electrodes on the upper surface of the power semiconductor chip 22 is electrically connected to the proximity portion 26b via a connecting member 28 such as a wire or clip. The control electrode on the upper surface of the power semiconductor chip 22 is electrically connected to the tip of the first electrode via a connecting member 29 such as a wire or clip. The connection between each electrode of the power semiconductor chip 22 and the first and second conductive parts 21a and 21b is not limited thereto. It is preferable to use clips rather than wires for either or both of the connecting member 28 and the connecting member 29, because this may allow the power module 1 to have a smaller dimension in the thickness direction.

Furthermore, both of the power semiconductor chip 12 and the power semiconductor chip 22 may be integrated into a single chip with a Free Wheeling Diode (FWD) reverse-connected to the power semiconductor element. Instead, the power semiconductor element may be integrated into a single chip, and a diode chip included in the FDW may be provided adjacent to this chip, and may be electrically connected thereto via a connecting member such as a wire or clip.

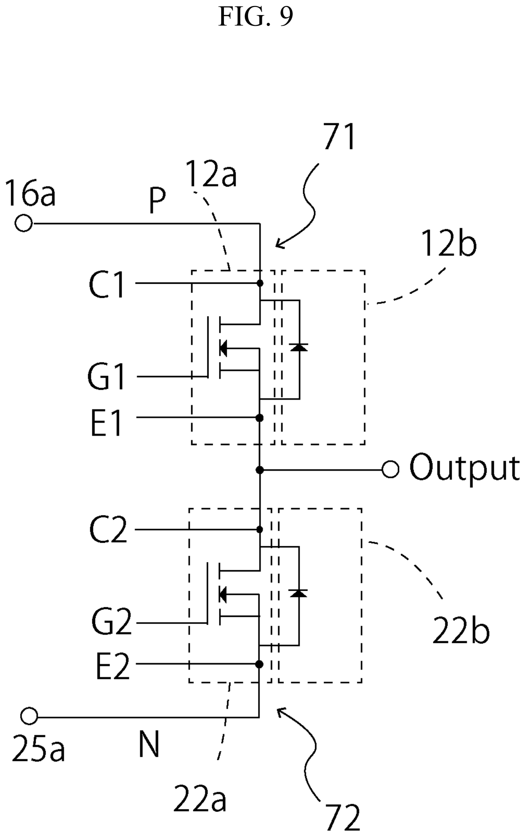

Next, a description will be given of another embodiment selectively applicable to the power module 1 according to the present invention. One power semiconductor chip 12 in the first substrate 10 and one corresponding power semiconductor chip 22 in the second substrate 20 form upper and lower arm circuits to output one phase AC current. FIG. 9 is a circuit diagram including the power module 1 shown in FIGs. 1 to 7. As shown in FIG. 9, an upper arm 71 includes a power semiconductor element 12a in the power semiconductor chip 12 and an FWD 12b either inside or outside the chip 12, and a lower arm 72 includes a power semiconductor element 22a in the power semiconductor chip 22 and an FWD 22b either inside or outside the chip 22.

By adopting such a circuit configuration, in the power module 1, the first DC connection terminal 16a of the second conductive part 11b mounted in the first substrate 10, and the second DC connection terminal 25a of the first conductive part 21a mounted in the second substrate 20 are connected to a capacitor (not shown), which connects in parallel with a chargeable/dischargeable battery. A converter (not shown) is connected to the battery. The converter converts AC from an AC generator or the like into DC and stores the electricity. The first AC connection terminal 15a of the first conductive part 11a in the first substrate 10, and the second AC connection terminal 26a of the second conductive part 21b in the second substrate 20 are connected to a load such as a motor (not shown). The DC from the battery may be converted into electric power by the power module 1 and output to the load. In the circuit shown in FIG. 9, the power semiconductor element 12a and the power semiconductor element 22a merely showing each terminal assuming IGBTs, and do not specify the type of power semiconductor element.

In each of the above described embodiments, the power module 1 may include the following first substrate 10 and second substrate 20. The first substrate 10 is configured by including three pairs of conductive parts 11 not connected to each other, a plurality of power semiconductor chips 12 connected to one of the conductive parts in each pair of conductive parts 11, and the cooler 13 for cooling the power semiconductor chips 12 provided on the surface where no conductive parts in each pair of conductive parts are provided. The second substrate 20 is configured by including three pairs of conductive parts 21 not connected to each other, a plurality of power semiconductor chips 22 connected to one of the conductive parts in each pair of conductive parts 21, and the cooler 23 for cooling the power semiconductor chips 22 provided on the side (surface) where no conductive parts in each pair of conductive parts 21 are provided. The three pairs of conductive parts may output three phases: U phase, V phase, and W phase.

In each of the above described embodiments, the pair of conductive parts 11 in the first substrate 10 and the pair of conductive parts 21 in the second substrate 20 are formed in a plate from a metal that has preferable thermal conductivity and electrical conductivity, such as copper. The portions of the conductive parts 11 and 21 through which a large current flows may also be called bus bars. The bus bars have a thickness of 0.3 mm or more and 1.0 mm or less. The first substrate 10 may be provided by forming on the insulating polyimide substrate 14a the metal layer 14b with a circuit pattern. The second substrate 20 may be provided by forming on the insulating polyimide substrate 24a the metal layer 24b with a circuit pattern.

It is preferable to use metal clips such as Cu rather than wire bonding between the power semiconductor chip 12 and the conductive part 11b and between the power semiconductor chip 12 and the conductive part 11b, because this may provide a lower height of the chip joint. The clips are not limited to the shapes shown in the figures.

The first flow path forming part 30 is made of, for example, various types of resins or metals (including alloys). If it is made of resin, it is bonded to the cooler 13, more particularly the plate portion 13a, such as by thermal bonding. If it is made of metal, it is connected to the cooler 13, more particularly the plate portion 13a, by welding. The type of the metal is preferably made of the same material as the cooler 13. This is because it is more easily welded to the cooler 13.

The cooler 13 and the cooler 23 are made of metal materials with good thermal conductivity, such as copper and aluminum. The second flow path forming part 40 is made of, for example, various types of resins or metals (including alloys). For the cooler 23, the plate portion 23a is liquid-tightly attached to the second flow path forming part 40 using a packing, a ring or the like.

The second flow path forming part 40 forms the second flow path 52 at least parallel along the second substrate 20, and at either or both of the inlet port and the discharge port, may be flush with the second flow path 52 as shown in FIGs. 1 and 2 or may have a corner or crank shape.

Next, specific embodiments will be described. Although the following description assumes that three-phase AC is output, when one phase AC is output, it may be applied by providing one pair of conductive parts 11 in the first substrate 10 and one pair of conductive parts 21 in the second substrate 20, and when two-phase AC is output, it may be applied by providing two pairs of conductive parts 11 in the first substrate 10 and two pairs of conductive parts 21 in the second substrate 20.

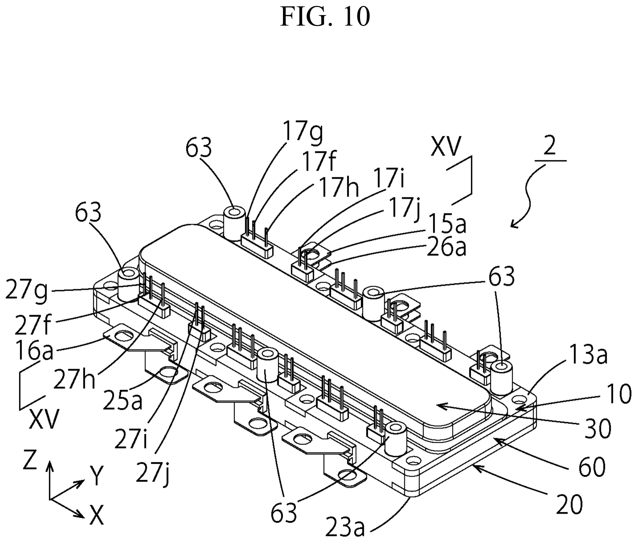

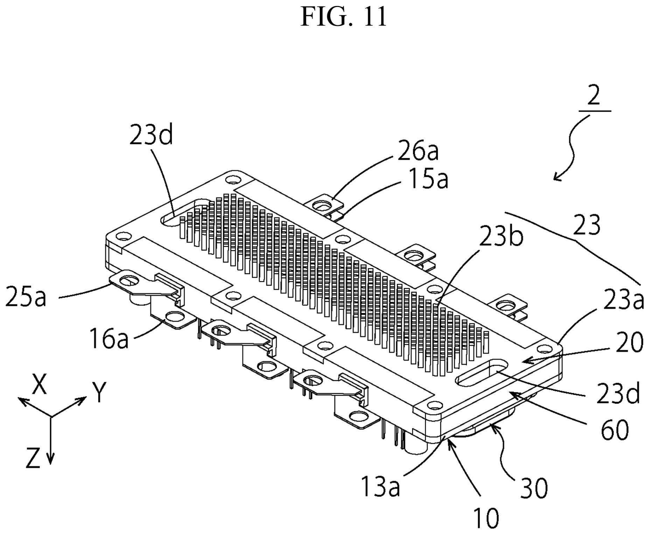

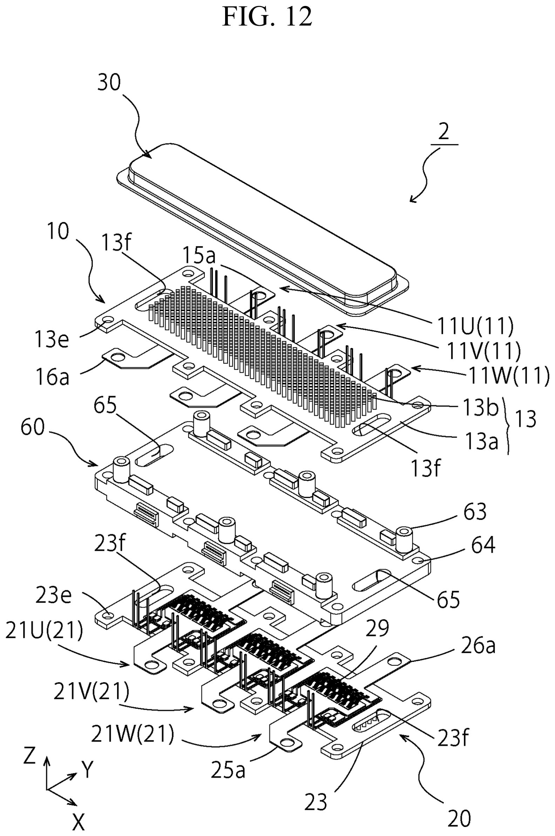

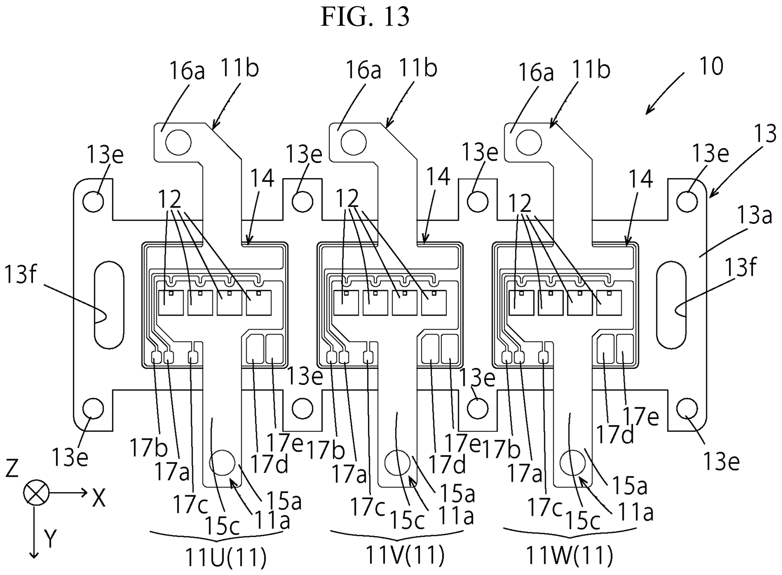

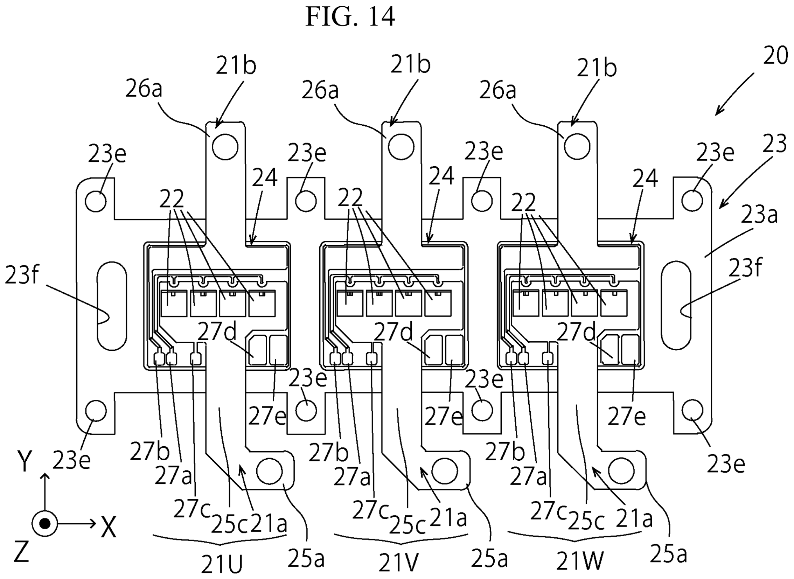

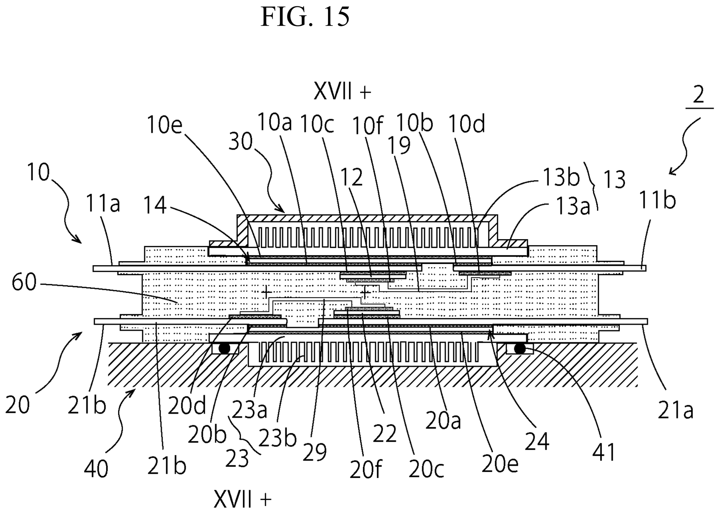

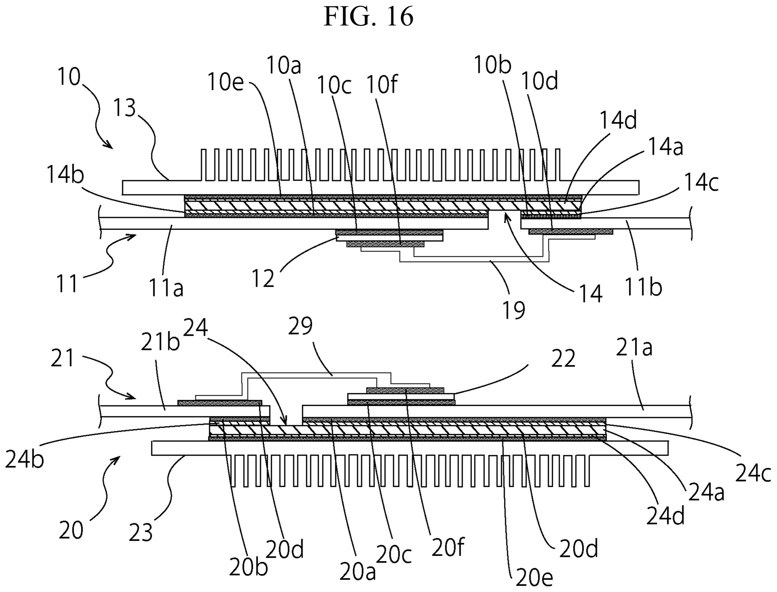

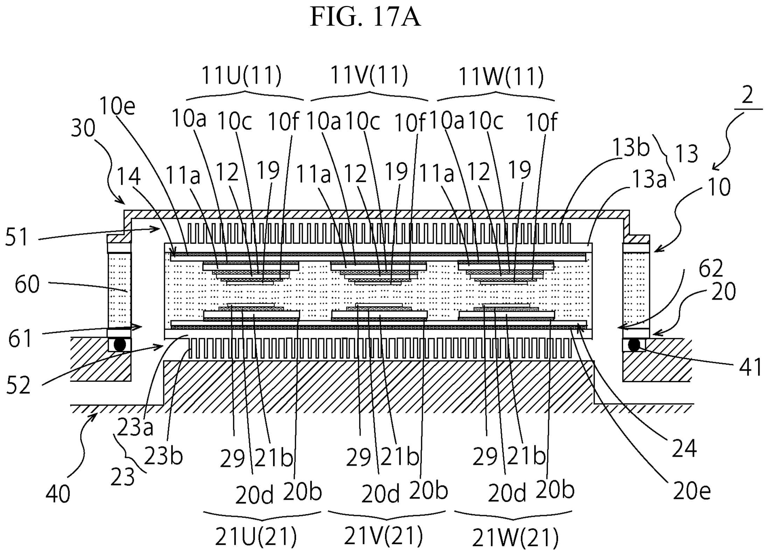

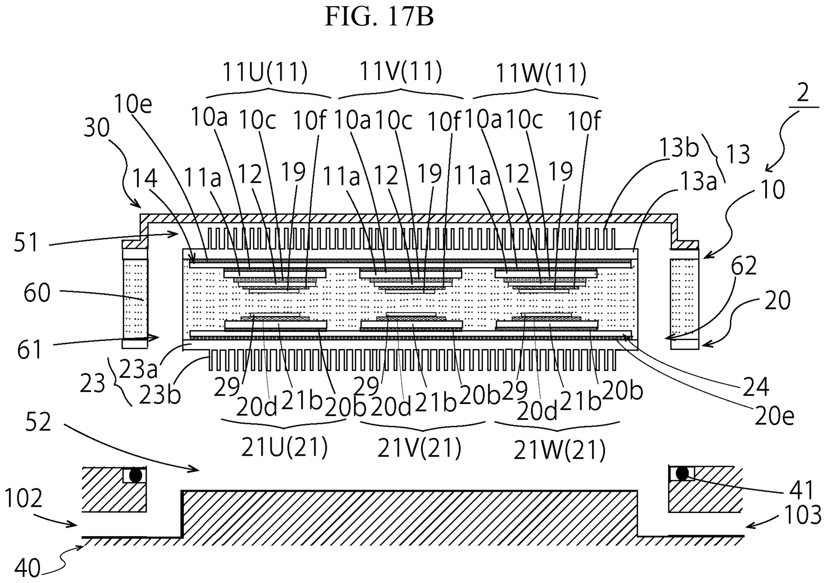

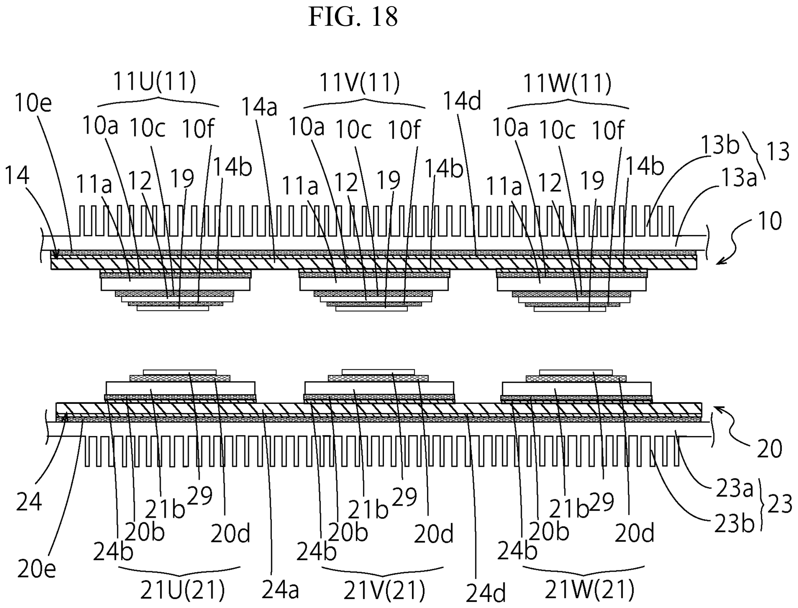

FIG. 10 is a perspective view from above of a power module 2 according to an embodiment of the present invention. FIG. 11 is a perspective view from below of a power module 2 according to an embodiment of the present invention. FIG. 12 is a perspective view of components of a power module 2 according to an embodiment of the present invention. FIG. 13 is a diagram showing a pair of conductive parts and a plate portion of a cooler in the first substrate in a power module 2 according to an embodiment of the present invention. FIG. 14 is a diagram showing a pair of conductive parts and a plate portion of a cooler in the second substrate in a power module 2 according to an embodiment of the present invention. FIG. 15 is a diagram showing a cross-sectional view along plane XV-XV in FIG. 10. FIG. 16 is a diagram showing a partially enlarged view of the cross-section shown in FIG. 15. FIG. 17A is a cross-sectional view along line XVII-XVII in FIG. 15. FIG. 17B is the cross-sectional view in FIG. 17A with the second substrate removed from the second flow path forming part. FIG. 18 is a partially enlarged view of the cross-section shown in FIG. 17A.

The power module 2 according to an embodiment of the present invention includes the first substrate 10, the second substrate 20, the first flow path forming part 30, and the second flow path forming part 40. The first substrate 10 is provided opposed to and spaced apart in the thickness direction from the second substrate 20. Like or corresponding parts and members are designated with like reference signs.

The first substrate 10 is configured by including three pairs of conductive parts 11 (11a, 11b) not connected to each other, a plurality of power semiconductor chips 12 connected to one of the conductive parts (the first conductive part 11a) in each pair of conductive parts 11 (11a, 11b), and the cooler 13 for cooling the power semiconductor chips 12. The three pairs of conductive part 11 include a first pair of conductive parts 11U, a second pair of conductive parts 11V, and a third pair of conductive parts 11W. Each pair of conductive parts 11U, 11V, and 11W is configured by including the first conductive part 11a and the second conductive part 11b as described above.

The second substrate 20 is configured by including three pairs of conductive parts 21 (21a, 21b) not connected to each other, a plurality of power semiconductor chips 22 connected to one of the conductive parts (the first conductive part 21a) in each pair of conductive parts 21 (21a, 21b), and the cooler 23 for cooling the power semiconductor chips 22. The three pairs of conductive part 21 include a first pair of conductive parts 21U, a second pair of conductive parts 21V, and a third pair of conductive parts 21W. Each pair of conductive parts 21U, 21V, and 23W is configured by including the first conductive part 21a and the second conductive part 21b as described above.

As shown in FIGs. 13 and 15 to 18, the first substrate 10 includes the circuit board 14, which includes three pairs of conductive parts: the first pair of conductive parts 11U, the second pair of conductive parts 11V, and the third pair of conductive parts 11W. Circuit patterns are formed on the first surface of the insulating substrate 14a for each pair using the metal layer 14b and the metal layer 14c. Regarding the first pair of conductive parts 11U, the metal layer 14b is connected to the first conductive part 11a via the bonding layer 10a, and the metal layer 14c is connected to the second conductive part 11b via the bonding layer 10b. The power semiconductor chip 12 is mounted on the first conductive part 11a on the opposite side to the bonding layer 10a and the bonding layer 10b via the bonding layer 10c. One end of the connecting member 19 such as a clip or wire is attached to the power semiconductor chip 12 on the opposite side to the first conductive part 11a via a bonding layer 10f. The other end of the connecting member 19 is attached to the second conductive part 11b via the bonding layer 10d. The same holds true for the second pair of conductive parts 11V and the third pair of conductive parts 11W.

On the second surface of the insulating substrate 14a, opposite to the first surface, the metal layer 14d is provided over the entire surface, rather than over each of the three pairs of conductive parts: the first pair of conductive parts 11U, the second pair of conductive parts 11V, and the third pair of conductive parts 11W. The plate portion 13a of the cooler 13 is provided on the metal layer 14d via a bonding layer 10e.

As shown in FIGs. 14 and 15 to 18, the second substrate 20 includes the circuit board 24, which includes three pairs of conductive parts: the first pair of conductive parts 21U, the second pair of conductive parts 21V, and the third pair of conductive parts 21W. Circuit patterns are formed on the first surface of the insulating substrate 24a for each pair using the metal layer 24b and the metal layer 24c. Regarding the first pair of conductive parts 21U, the metal layer 24b is connected to the first conductive part 21a via the bonding layer 20a, and the metal layer 24c is connected to the second conductive part 21b via the bonding layer 20b. The power semiconductor chip 22 is mounted on the first conductive part 21a on the opposite side to the bonding layer 20a and the bonding layer 20b via the bonding layer 20c. One end of the connecting member 29 such as a clip or wire is attached to the power semiconductor chip 22 on the opposite side to the first conductive part 21a via a bonding layer 20f. The other end of the connecting member 29 is attached to the second conductive part 21b via the bonding layer 20d. The same holds true for the second pair of conductive parts 21V and the third pair of conductive parts 21W.

On the second surface of the insulating substrate 24a, opposite to the first surface, the metal layer 24d is provided over the entire surface, rather than over each of the three pairs of conductive parts: the first pair of conductive parts 21U, the second pair of conductive parts 21V, and the third pair of conductive parts 21W. The plate portion 23a of the cooler 23 is provided on the metal layer 24d via a bonding layer 20e.

As shown in FIG. 13, in the first substrate 10, each of the first conductive parts 11a has a plurality of, specifically four, power semiconductor chips 12 mounted thereon, and the metal layer on the circuit board 14 forms the first electrode connection 17a, the second electrode connection 17b, and the third electrode connection 17c. In addition, the metal layer on the circuit board 14 forms a first electrode 17d of a thermistor and a second electrode 17e of the thermistor. The thermistor is mounted on the first electrode 17d and the second electrode 17e. The connections 17a, 17b, and 17c are connected to corresponding control pins 17f, 17g, and 17h, respectively, which may be L-shaped, for example, as shown in FIGs. 10 and 12. The first electrode 17d and the second electrode 17e are connected to corresponding pins 17i and 17j, respectively, which may be L-shaped, for example, as shown in FIG. 10. Each of the control pins 17f, 17g, 17h, and pins 17i, 17j is connected to a control substrate (not shown) attached to a plurality of support parts 63 of the power module 2, and is configured to control the power module 2 through input/output of control signals and a signal output from the thermistor.

As shown in FIG. 14, in the first substrate 20, each of the first conductive parts 21a has a plurality of, specifically four, power semiconductor chips 22 mounted thereon, and the metal layer on the circuit board 24 forms the first electrode connection 27a, the second electrode connection 27b, and the third electrode connection 27c. In addition, the metal layer on the circuit board 24 forms a first electrode 27d of a thermistor and a second electrode 27e of the thermistor. The thermistor is mounted on the first electrode 27d and the second electrode 27e. The connections 27a, 27b, and 27c are connected to corresponding control pins 27f, 27g, and 27h, respectively, which may be L-shaped, for example, as shown in FIGs. 10 and 12. The first electrode 27d and the second electrode 27e are connected to corresponding pins 27i and 27j, respectively, which may be L-shaped, for example, as shown in FIG. 10. Each of the control pins 27f, 27g, 27h, and pins 27i, 27j is connected to a control substrate (not shown) attached to a plurality of support parts 63 of the power module 2, and is configured to control the power module 2 through input/output of control signals and a signal output from the thermistor.

As shown in FIGs. 12, 15 and 17A, the plate portion 13a of the cooler 13 has a flow path through-hole 13f at both ends in the X-axis direction (the direction in which the three pairs of conductive parts 11 are arranged), and the plate portion 23a of the cooler 23 has a flow path through-hole 23f at both ends in the X-axis direction, and the flow path through-hole 13f and the flow path through-hole 23f are liquid-tightly and communicably connected to a through-holes 65 of the sealing part 60. Here, each of the flow path through-holes 13f, the flow path through-holes 23f, and the through-holes 65 may be a long hole as shown in the figures, or may include a plurality of holes.

The cooler 13 and the cooler 23 include the plate portion 13a and the plate portion 23a, respectively. The plate portions 13a and 23a have a shape symmetrical to each other. The plate portion 13a and 23a include a corresponding flow path through-hole 13f and flow path through-hole 23f, respectively, at both ends in the X-axis direction. Each plate portion 13a and 23a has an extension at both ends in the X-axis direction. The extension extends to both sides in the Y-axis direction (the direction in which the first conductive part 11a and the second conductive part 11b extend). Each plate portion 13a and 23a also has an extension at the regions where the first conductive part 11a and the second conductive part 11b are not provided. The extension extends to both sides in the Y-axis direction. Each of these extensions has a fastening through-hole 13e or a fastening through-hole 23e.

In the first substrate 10, the control pins 17f, 17g, 17h and pins 17i, 17j are provided for each pair. Each of the control pins 17f, 17g, 17h and pins 17i, 17j includes a first extension portion that extends in one direction of the Y-axis direction of the sealing part 60, and a second extension portion that extends upward from the first extension portion. The second extension portion of each control pin 17f, 17g, 17h is partially held by a fixed part extending in the X-axis direction at the Y-axis direction end of the sealing part 60, and extends upward.

In the second substrate 20, the control pins 27f, 27g, 27h and pins 27i, 27j are provided for each pair. Each of the control pins 27f, 27g, 27h and pins 27i, 27j includes a first extension portion that extends in the other direction of the Y-axis direction of the sealing part 60, and a second extension portion that extends upward from the first extension portion. The second extension portion of each control pin 27f, 27g, 27h is partially held by a fixed part extending in the X-axis direction at the Y-axis direction end (an end in the -Y-axis direction) of the sealing part 60, and extends upward.

In the first substrate 10, the extension portion 15c of the first conductive part 11a is disposed between the control pins 17f, 17g, 17h and the pins 17i, 17j. The first AC connection terminal 15a is provided on the tip side of the extension portion 15c. The first conductive part 11a is configured to protrude the first AC connection terminal 15a outward from the sealing part 60, specifically, outward from portions that hold the control pins 17f, 17g, 17h and pins 17i, 17j and are formed by fixed parts that are parts of the sealing part 60. In addition, the second conductive part 11b is configured to protrude the first DC connection terminal 16a outward from the sealing part 60. Both of the first conductive part 11a and the second conductive part 11b are configured to extend beyond the plate portion 13a of the cooler 13 to the corresponding side in the Y-axis direction.

In the second substrate 20, the extension portion 25c of the first conductive part 21a is disposed between the control pins 27f, 27g, 27h and the pins 27i, 27j. The second DC connection terminal 25a is provided on the tip side of the extension portion 25c. The first conductive part 21a is configured to protrude the second DC connection terminal 25a outward from the sealing part 60, specifically, outward from portions that hold the control pins 27f, 27g, 27h and pins 27i, 27j and are formed by fixed parts that are parts of the sealing part 60. The portions that hold the control pins 27f, 27g, 27h and pins 27i, 27j are provided on the opposite side of the Y-axis direction (the direction in which the extension portion 26c extends) and offset in the Z-axis direction (the thickness direction of the power module 2) from the portions that hold the control pins 17f, 17g, 17h and pins 17i, 17j. In addition, the second conductive part 21b is configured to protrude the second AC connection terminal 26a outward from the sealing part 60. Both of the first conductive part 21a and the second conductive part 21b are configured to extend beyond the plate portion 23a of the cooler 23 to the corresponding side in the Y-axis direction.

The first substrate 10 and the second substrate 20 are opposed to each other, and a molded part as the sealing part 60 is formed by sealing using, for example, transfer molding, thereby sandwiching the sealing part 60 between the first substrate 10 and the second substrate 20, as shown in FIGs. 10 and 11. As shown in FIG. 12, the fastening through-hole 13e in the plate portion 13a of the cooler 13 and the through-hole 23e in the plate portion 23a of the cooler 23 in the second substrate 20 are provided at the four corners of each plate portion 13a, 23a, and at the intermediate positions of the longitudinal ends and of the gap between the first conductive part 11a and the second conductive part 21b. Not-shown fastening members are attached by being inserted through the fastening through-holes 13e, a through-holes 64 of the sealing part 60, and the fastening through-holes 23e.

As shown in FIG. 17A, the power module 2 according to an embodiment of the present invention includes the second flow path forming part 40 in which the upstream and downstream sides of the first flow path 51 have a bent shape. The flow extends from a not-shown inlet port in directions that intersect at generally right angles, passes through the branch section 61, split into the first flow path 51 and the second flow path 52, which flow parallel to each other above and below. The first flow path 51 bends, passes through the confluence section 62, meets with the second flow path 52, flows in the thickness direction and bends, and is then discharged from the outlet port.

As shown in FIGs. 11 and 12, the first flow path forming part 30 is dish-shaped, with the flange part being in close contact with the plate portion 13a. When the first flow path forming part 30 is made of metal, it is in close contact with the plate portion 13a of the cooler 13 in the first substrate 10 by welding or the like. When the first flow path forming part 30 is made of resin, it is in close contact with the plate portion 13a of the cooler 13 in the first substrate 10 by welding or the like.

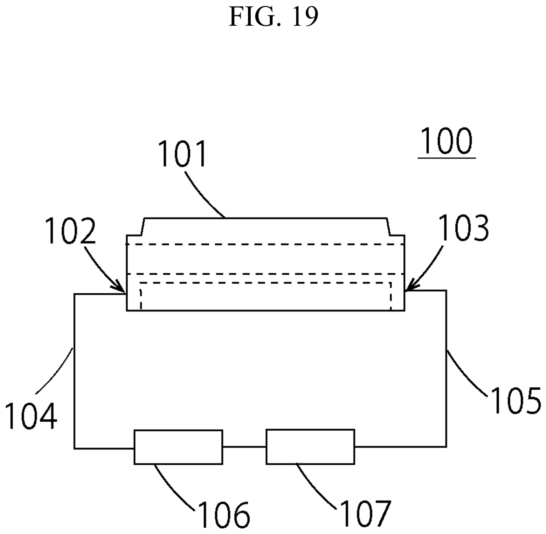

As shown in FIGs. 15 and 17A, the plate portion 23a of the cooler 23 in the second substrate 20 is liquid-tightly attached to the second flow path forming part 40 via a packing or sealant 41. As shown in FIG. 17B, power module component including the second substrate 20, the sealing part 60, the first substrate 10, and the first flow path forming part are removable from the second flow path forming part 40, and are liquid-tightly attached to the flange part of the second flow path forming part 40 via the packing or sealant 41. Thus, the refrigerant is sent in from the outside (specifically, the upstream pipe 104 in FIG. 19), flows through an inlet port 102, the branch section 61 in order, splits into the first flow path 51 and the second flow path 52, is combined at the confluence section 62, and is sent out from an outlet port 103 to the outside (specifically, the downstream pipe 105 in FIG. 19).

According to an embodiment of the present invention, three-phase AC may be output as the inverter output, and the power module component may be attached to a part of the case of the power conversion device as the second flow path forming part 40 or to the second flow path forming part 40 provided in the case, without providing the inlet port and outlet port of the refrigerant for each phase. In so doing, the first flow path 51 and the second flow path 52 form an upper/lower two-tier structure or a two-story structure, and the upper and lower power semiconductor chips 12, 22 and the corresponding first conductive parts 11a and 21a and second conductive parts 11b and 21b form the upper arm and lower arm, respectively, thereby arranging the power semiconductor chips three-dimensionally rather than two-dimensionally. Thus, excluding the second flow path forming part, the power module may have dimensions of 130 mm x 50 mm x 20 mm, a maximum current of 200A to 400A, a maximum voltage 400V, and may include four 5 mm square power semiconductor chips in parallel, one on each of the upper arm and lower arm, and may adopt a direct water cooling system. Compared to conventional configurations in which the power semiconductor chips are not arranged three-dimensionally, but the power semiconductor chip for the upper arm and the power semiconductor chip for the lower arm are provided on one surface, the thickness dimension of the power module may be kept roughly the same and the planar dimensions may be reduced to about half, thereby decreasing the size of the power conversion device itself.

FIG. 19 is a block diagram of a power conversion device including a power module according to an embodiment of the present invention. In a power conversion device 100, a power module 101 includes one inlet port 102 and one outlet port 103, with the inlet port 102 connected to an upstream pipe 104 and the outlet port 103 connected to a downstream pipe 105. The upstream pipe 104 is connected to a radiator 106. The downstream pipe 105 is connected to a pump 107. The medium cooled by the radiator 106 flows from the upstream pipe 104 to the inlet port 102 under the pressure of the pump 107. Then, the medium flows through the branch section 61 shown in FIGs. 1 to 7, FIGs. 15 and 17A, splits into the first flow path and the second flow path, and then flows through the confluence section 62, and flows from the outlet port 103 to the downstream pipe 105. Note that the order of the radiator 106 and the pump 107 may be reversed.

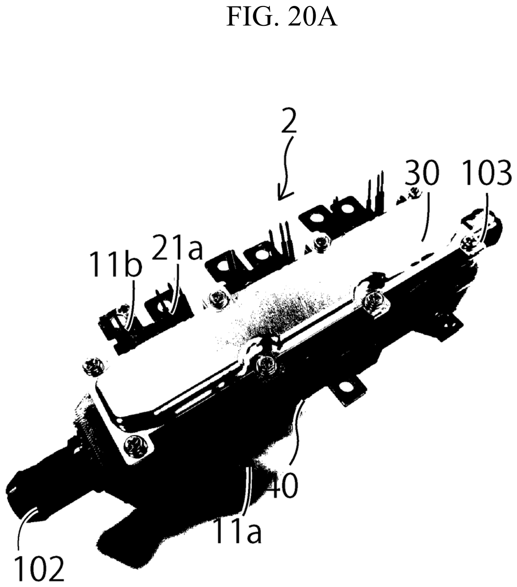

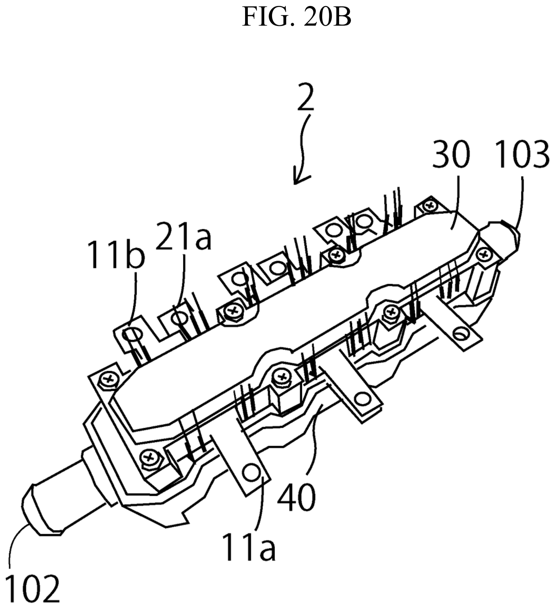

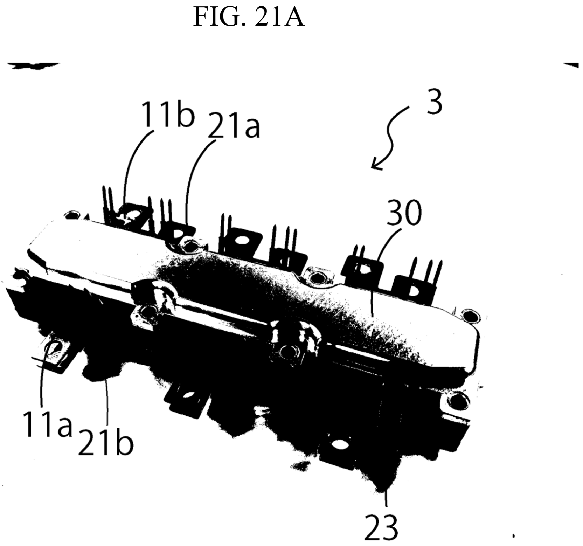

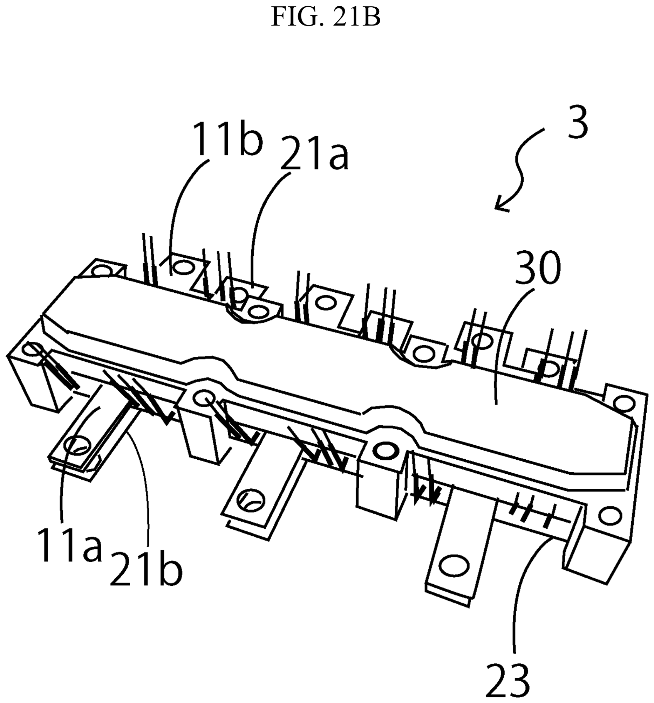

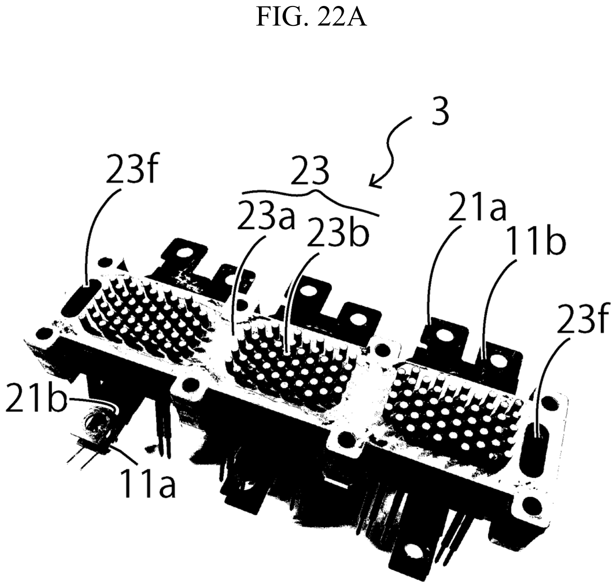

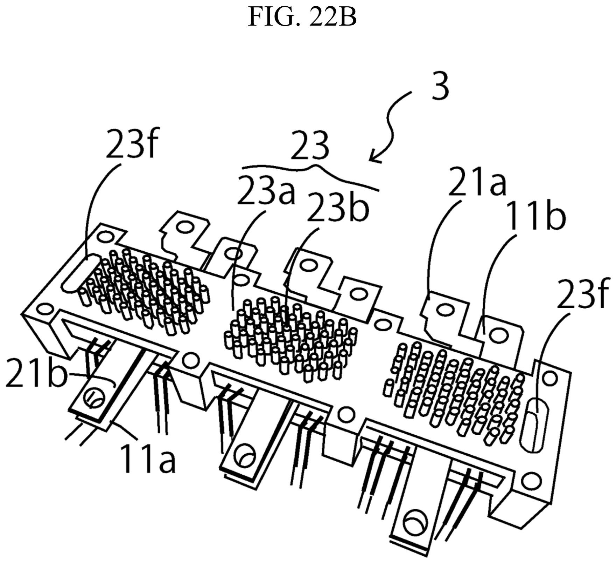

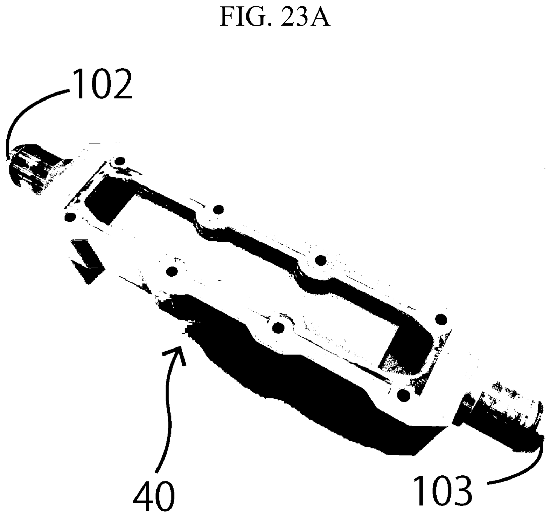

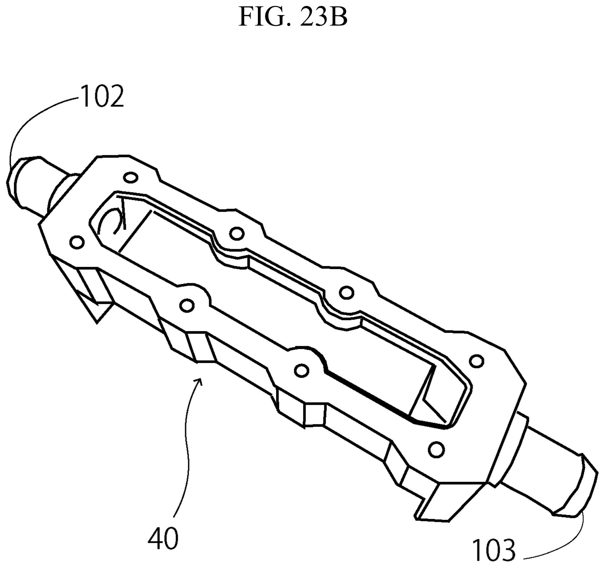

FIG. 20A is an image of a prototype power module as viewed from diagonally above. FIG. 21A is an image of the power module component removed from the second flow path forming part of the prototype power module, as viewed from diagonally above. FIG. 22A is an image of the power module component with the second substrate facing up. FIG. 23A is an image of the second flow path forming part of the prototype power module. FIG. 20B, FIG. 21B, FIG. 22B, and FIG. 23B are the main outlines of FIG. 20A, FIG. 21A, FIG. 22A, and FIG. 23A, respectively. The reference signs used in these figures are those shown in FIGs. 10 to 18. For example, the plate portion 23a of the cooler 23 has flow path through-holes (holes that penetrate) 23f of long holes provided at both ends in the longitudinal direction. The packing or sealant 41 (see FIGs. 15 and 17B) is attached to the periphery of the upper surface opening of the second flow path forming part 40, and the protrusions 23b of the cooler 23 of the power module component 3 are inserted from the upper surface opening of the second flow path forming part 40 and attached. The second flow path forming part 40 includes one inlet port 102 and one outlet port 103. The planar dimensions of the power module may be reduced to about half. It was confirmed that the power module component 3 including the first substrate, the second substrate, and the first flow path forming part are removable from the second flow path forming part 40, and that there is no leakage of the cooling medium due to the seal by the packing or sealant 41 between the second flow path forming part 40 and the plate portion 23a of the cooler 23.

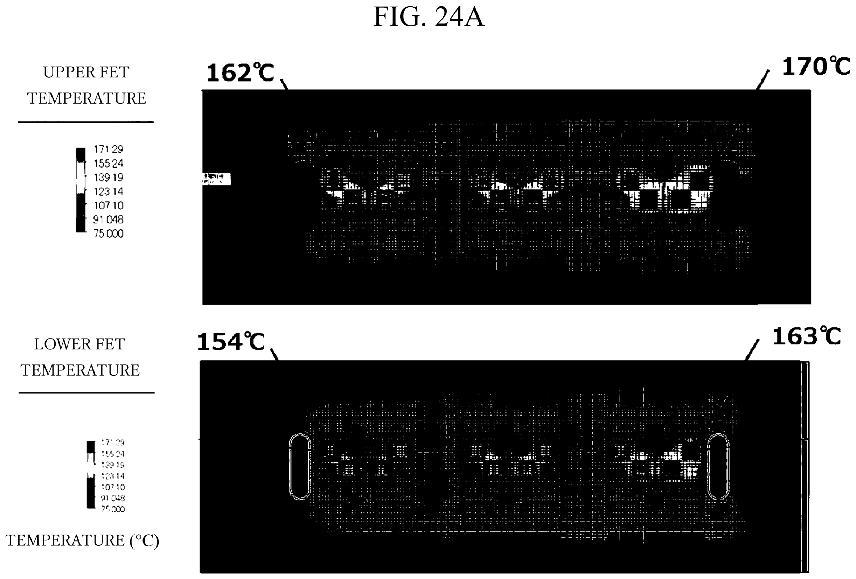

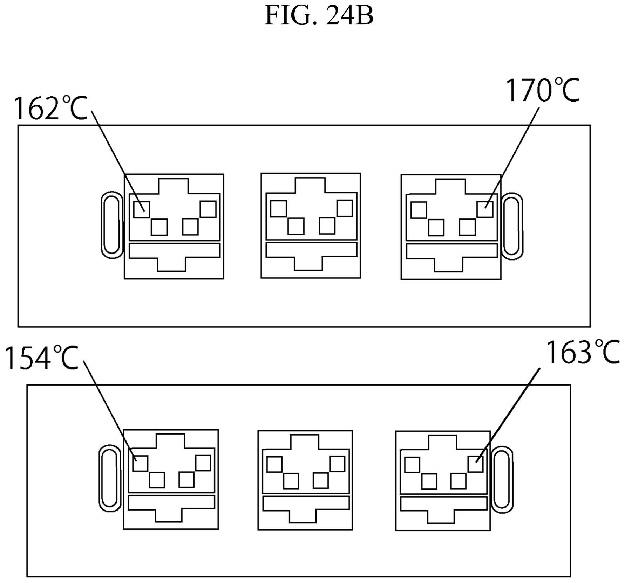

FIG. 24A is a diagram showing the results of simulating heat distribution in a power module included in a three-phase inverter. FIG. 24B is a diagram showing the simulation results in FIG. 24A along with the outlines of the first conductive part, the second conductive part, and the power semiconductor chip. The upper part in each of FIGs. 24A and 24B shows the temperature distribution or outline of the first substrate. The lower part shows the temperature distribution or outline of the second substrate. It is assumed that U phase, V phase, W phase are output from left to right in the figure, and corresponding to each phase, both of the first substrate and second substrate have the first conductive part and the second conductive part arranged thereon, the first conductive part has four power semiconductor chips mounted thereon, and the cooling medium flows from one of the left and right long holes to the other.

The simulation results show as follows. Among the power semiconductor chips mounted on the first conductive part of the U phase in the first substrate, the chip arranged closest to the long hole was at a high temperature (162 °C), among the power semiconductor chips mounted on the first conductive part of the W phase in the first substrate, the power semiconductor chip arranged closest to the long hole was at a high temperature (170 °C), among the power semiconductor chips mounted on the first conductive part of the U phase in the second substrate, the power semiconductor chip arranged closest to the long hole was at a high temperature (154 °C), and among the power semiconductor chips mounted on the first conductive part of the W phase in the second substrate, the power semiconductor chip arranged closest to the long hole was at a high temperature (163 °C). As a result, it was found that even when the flow path is provided in the upper/lower two-tier, cooling is almost uniform on both the branch section side and the confluence section side.

The power module (1, 2) according to an embodiment of the present invention includes: a first substrate (10) configured to include at least one pair of conductive parts (11a, 11b) not connected to each other, one or more power semiconductor chips (12) connected to any of the conductive parts, and a cooler (13) provided on a side where no conductive parts are provided, the cooler (13) being for cooling the power semiconductor chip;
a second substrate (20) configured to include at least one pair of conductive parts (21a, 21b) not connected to each other, one or more power semiconductor chips (22) connected to any of the conductive parts, a cooler (23) provided on a side where no conductive parts are provided, the cooler (23) being for cooling the power semiconductor chip;
a first flow path forming part (30) provided on a side of the first substrate where the cooler (13) is provided, the first flow path forming part (30) forming a first flow path (51) for flowing a refrigerant to the cooler (13) in the first substrate together with the first substrate; and
a second flow path forming part (40) provided on a side of the second substrate where the cooler (23) is provided, the second flow path forming part (40) forming a second flow path (52) for flowing a refrigerant to the cooler (23) in the second substrate together with the first substrate,
a surface of the side of the first substrate where the pair of conductive parts are provided is opposed to and spaced apart from a surface of the side of the second substrate where the pair of conductive parts are provided.

Here, the power module (1, 2) is configured by including the first substrate (10) and the second substrate (20) sandwiched by the first flow path forming part (30) and the second flow path forming part (40). In addition, the first substrate (10) includes the circuit board (14), with the conductive parts (11a, 11b) provided on the first surface (the surface facing the second substrate) of the circuit board, and the cooler (13) provided on the second surface (the surface opposite to the first surface) of the circuit board. The second substrate (20) includes the circuit board (24), with the conductive parts (11a, 11b) provided on the first surface (the surface facing the second substrate) of the circuit board, and the cooler (23) provided on the second surface (the surface opposite to the first surface) of the circuit board.

When a plurality of power semiconductor chips are mounted, they are arranged in a direction intersecting the direction in which each of the extension portions of the mounted conductive parts extends. This may reduce the depth dimension of the power semiconductor module.

The pair of conductive parts in the first substrate are formed to extend oppositely to each other in directions intersecting the first flow path, the other of the conductive parts (the second conductive part 11b) includes the first DC connection terminal (16a). The pair of conductive parts in the second substrate are formed to extend oppositely to each other in directions intersecting the second flow path, one of the pair of conductive parts (the first conductive part 21a) includes the second DC connection terminal (25a). The direction of the DC flowing through the second conductive part 11b is opposite to the direction of the DC flowing through the first conductive part 21a. This may reduce the inductance generated on the first substrate and the second substrate.

The present invention is based on the following concepts.
[1] A power module (1, 2) including: a first substrate (10) configured to include at least one pair of conductive parts (11a, 11b) not connected to each other, one or more power semiconductor chips (12) connected to any of the conductive parts, and a cooler (13) provided on a side where no conductive parts are provided, the cooler (13) being for cooling the power semiconductor chip;
   a second substrate (20) configured to include at least one pair of conductive parts (21a, 21b) not connected to each other, one or more power semiconductor chips (22) connected to any of the conductive parts, a cooler (23) provided on a side where no conductive parts are provided, the cooler (23) being for cooling the power semiconductor chip (22);
   a first flow path forming part (30) provided on a side of the first substrate where the cooler (13) is provided, the first flow path forming part (30) forming a first flow path (51) for flowing a refrigerant to the cooler (13) in the first substrate together with the first substrate; and
   a second flow path forming part (40) provided on a side of the second substrate where the cooler (23) is provided, the second flow path forming part (40) forming a second flow path (52) for flowing a refrigerant to the cooler (23) in the second substrate together with the second substrate,
   a surface of the side of the first substrate where the pair of conductive parts are provided being opposed to and spaced apart from a surface of the side of the second substrate where the pair of conductive parts are provided.
[2] The power module (1,2) according to [1], further including a branch section (61) connecting the first flow path and the second flow path.
[3] The power module (1, 2) according to [1] or [2], wherein the cooler (13) of the first substrate includes a plate portion (13a), the cooler (23) of the second substrate includes a plate portion (23a), and each plate portion includes through-hole, the through-hole providing a branch into the first flow path and the second flow path.
[4] The power module (1, 2) according to any one of [1] to [3], wherein each of the coolers (13, 23) in the first substrate and the second substrate includes a plate portion (13a, 23a) and a plurality of protrusions (13b, 23b) extending from the plate portion to the corresponding flow path.
[5] The power module (1, 2) according to [4], wherein the protrusions (13b) of the cooler in the first substrate differ from the protrusions (23b) of the cooler in the second substrate in at least one of the dimensions of the protrusions themselves, the distance between the protrusions, and the distance between the tips of the protrusions and a corresponding flow path forming part.
[6] The power module according to any one of [1] to [5], wherein each of the first substrate and the second substrate is configured to include a plurality of metal layers (14b, 14c, 24b, 24c) on which an interconnection pattern is formed on a corresponding insulating substrate (14a, 24a).
[7] The power module according to any one of [1] to [6], wherein the pair of conductive parts in the first substrate are formed to extend oppositely to each other in directions intersecting the first flow path, one of the pair of conductive parts (the first conductive part 11a) includes a first AC connection terminal (15a), and the other of conductive parts (the second conductive part 11b) includes a first DC connection terminal (16a),
   the pair of conductive parts in the second substrate are formed to extend oppositely to each other in directions intersecting the second flow path, one of the pair of conductive parts (the first conductive part 21a) includes a second DC connection terminal (25a), and the other of conductive parts (the second conductive part 21b) includes a second AC connection terminal (26a),
   one of the pair of conductive parts in the second substrate (the extension portion 25c of the first conductive part 21a) includes a portion identical in shape to the other of the pair of conductive parts in the first substrate (the extension portion 16c of the second conductive part 11b), and
   a current flowing between the first DC connection terminal (16a) and the power semiconductor chip (12) in the first substrate is configured to be opposite to a current flowing between the second DC connection terminal (25a) and the power semiconductor chip (22) in the second substrate.
[8] The power module according to any one of [1] to [7], wherein one of the power semiconductor chip (12) in the first substrate and a corresponding one of the power semiconductor chip (22) in the second substrate form upper and lower arms to output one phase AC current.

The embodiments of the present invention are not limited to the forms shown, and may be modified as appropriate without departing from the technical scope of the present invention. In addition, the metal layers and the bonding layers used to connect or bond each member and part may be made of a single layer or a plurality of layers. The metal layer includes an alloy layer.

### REFERENCE SIGNS LIST

1: Power module
2: Power module
3: Power module component
10: First substrate
10a, 10b, 10c, 10d, 10e, 10f, 20a, 20b, 20c, 20d, 20e, 20f: Bonding layer
11, 11U, 11V, 11W, 21, 21U, 21V, 21W: Conductive part
11a, 21a: First conductive part
11b, 21b: Second conductive part
12, 22: Power semiconductor chip
13, 23: Cooler
13a, 23a: Plate portion
13b, 23b: Protrusion
13c, 13d: Cooling pipe
13e, 23e: Fastening through-hole
13f, 23f: Flow path through-hole
14, 24: Circuit board
14a, 24a: Insulating substrate
14b, 14c, 14d, 24b, 24c, 24d: Metal layer
15a: First AC connection terminal
15b, 25b: Chip mounting portion
15c, 25c: Extension portion
16a: First DC connection terminal
16b, 26b: Proximity portion
16c, 26c: Extension portion
17a, 27a: First electrode connection
17b, 27b: Second electrode connection
17c, 27c: Third electrode connection
17d, 27d: First electrode of thermistor
17e, 27e: Second electrode of thermistor
17f, 17g, 17h, 27f, 27g, 27h: Control pin
17i, 17j, 27i, 27j: Pin
18, 19, 28, 29: Connecting member
20: Second substrate
25a: Second DC connection terminal
26a: Second AC connection terminal
30: First flow path forming part
40: Second flow path forming part
51: First flow path
52: Second flow path
60: Sealing part
61: Branch section
62: Confluence section
63: Support part
64: Through-hole
65: Through-hole
71: Upper arm
72: Lower arm
3: Power module component
102: Inlet port
103: Outlet port

## Claims

1. A power module comprising:
a first substrate configured to include at least one pair of conductive parts not connected to each other, one or more power semiconductor chips connected to any of the conductive parts, and a cooler provided on a side where no conductive parts are provided, the cooler being for cooling the power semiconductor chip;
a second substrate configured to include at least one pair of conductive parts not connected to each other, one or more power semiconductor chips connected to any of the conductive parts, and a cooler provided on a side where no conductive parts are provided, the cooler being for cooling the power semiconductor chip;
a first flow path forming part provided on a side of the first substrate where the cooler is provided, the first flow path forming part forming a first flow path for flowing a refrigerant to the cooler in the first substrate together with the first substrate; and
a second flow path forming part provided on a side of the second substrate where the cooler is provided, the second flow path forming part forming a second flow path for flowing a refrigerant to the cooler in the second substrate together with the first substrate, wherein
a surface of the side of the first substrate where the pair of conductive parts are provided is opposed to and spaced apart from a surface of the side of the second substrate where the pair of conductive parts are provided.

2. The power module according to claim 1, further comprising
a branch section connecting the first flow path and the second flow path.

3. The power module according to claim 1 or 2, wherein
the cooler of the first substrate includes a plate portion,
the cooler of the second substrate includes a plate portion, and
each plate portion includes respective through-hole, the through-hole providing a branch into the first flow path and the second flow path.

4. The power module according to claim 1 or 2, wherein
each of the coolers in the first substrate and the second substrate includes a plate portion and a plurality of protrusions extending from the plate portion to a corresponding flow path.

5. The power module according to claim 4, wherein
the protrusions of the cooler in the first substrate differ from the protrusions of the cooler in the second substrate in at least one of dimensions of the protrusions themselves, a distance between the protrusions, and a distance between tips of the protrusions and a corresponding flow path forming part.

6. The power module according to claim 1, wherein
each of the first substrate and the second substrate is configured to include a plurality of metal layers on which an interconnection pattern is formed on an insulating substrate.

7. The power module according to claim 1, wherein
the pair of conductive parts in the first substrate are formed to extend oppositely to each other in directions intersecting the first flow path, one of the pair of conductive parts includes a first AC connection terminal, and another of the pair of conductive parts includes a first DC connection terminal,
the pair of conductive parts in the second substrate are formed to extend oppositely to each other in directions intersecting the second flow path, one of the pair of conductive parts includes a second DC connection terminal, and another of conductive parts includes a second AC connection terminal,
one of the conductive parts of a pair in the second substrate includes a portion identical in shape to the other of the conductive parts of the pair in the first substrate, and
a current flowing between the first DC connection terminal and the power semiconductor chips in the first substrate is configured to be opposite to a current flowing between the second DC connection terminal and the power semiconductor chips in the second substrate.

8. The power module according to claim 1, wherein
one of the power semiconductor chips in the first substrate and a corresponding one of the power semiconductor chips in the second substrate form upper and lower arms to output one phase AC current.
